# EUROPEAN PATENT APPLICATION

(11) **EP 4 765 090 A1**
(43) Date of publication of application: **24.06.2026**
(21) Application number: 25213688.2
(22) Date of filing: 05.11.2025
(51) Int. Cl.: G09G 3/3266, G11C 19/28, G09G 3/36

(54) **GATE DRIVER AND DISPLAY DEVICE INCLUDING THE SAME**

(30) Priority: 23.12.2024 KR 20240193939
(71) Applicant: LG Display Co., Ltd., Seoul, 07336 (KR)
(72) Inventor: SANG, WooKyu, Paju-si, Gyeonggi-do 10845 (KR); CHUNG, Moonsoo, Paju-si, Gyeonggi-do 10845 (KR)
(74) Representative: Viering, Jentschura & Partner mbB Patent- und Rechtsanwälte

(57) **Abstract**

A gate driver (120, 620, 1020, 1220, 1420, 1520) includes a plurality of stages (STG1, ..., STG16) which is cascaded and outputs a plurality of gate signals (GATE1, ..., GATE16) based on an input signal, a plurality of clock signals (CLK1, CLK2), a plurality of control clock signals (CCLK1, CCLK2), a first power source (VGH), and a second power source (VGL) which has a voltage level lower than that of the first power source (VGH), each of the plurality of stages (STG1, ..., STG16) includes a carry circuit (CRY1, ..., CRY16) which outputs a carry signal (CR1, ..., CR16) based on the input signal, at least one of the plurality of clock signals (CLK1, CLK2), the first power source (VGH), and the second power source (VGL) and an output circuit (OUT1, ..., OUT16) which outputs a gate signal (GATE1, ..., GATE16) based on the carry signal (CR1, ..., CR16), at least one of the plurality of control clock signals (CCLK1, CCLK2), the first power source (VGH), and the second power source (VGL), and whether to output the gate signal (GATE1, ..., GATE16) of the output circuit (OUT1, ..., OUT16) is controlled based on at least one control clock signal (CCLK1, CCLK2).

## Description

### BACKGROUND

### 1. Technical Field

The present disclosure relates to a gate driver and a display device including the same, and particularly to, for example, without limitation, a gate driver which controls a driving frequency and a display device including the same.

### 2. Description of Related Art

As it enters an information era, a display field which visually expresses electrical information signals has been rapidly developed, and in response to this, various display devices having excellent performances such as thin-thickness, light weight, and low power consumption have been developed. Examples of such a display device include a liquid crystal display device (LCD) and an organic light emitting display device (OLED).

Such a display device includes a display panel in which a plurality of pixels for displaying images is disposed and a driving circuit. The driving circuit includes a data driver which supplies a data signal to the plurality of pixels through a plurality of data lines, a gate driver which supplies a gate signal to the plurality of pixels through a plurality of gate lines, and a timing controller which controls the data driver and the gate driver.

The description of related art should not be considered prior art merely because it is mentioned in or associated with this section. The description of related art includes information that describes one or more aspects of the subject technology, and the description in this section does not limit the scope of the invention.

### SUMMARY

An aspect of the present disclosure provides a gate driver which controls a driving frequency for each area of the display panel and a display device including the same.

Aspects of the present disclosure are not limited to the above-mentioned aspects, and other aspects, which are not mentioned above, can be clearly understood by those skilled in the art from the following descriptions. According to an aspect of the present disclosure, a gate driver according to claim 1 is provided. Further embodiments are described in the dependent claims.

According to one or more aspects of the present disclosure, a gate driver includes a plurality of stages which is cascaded and outputs a plurality of gate signals based on an input signal, a plurality of clock signals, a plurality of control clock signals, a first power source, and a second power source which has a voltage level lower than that of the first power source, each of the plurality of stages includes a carry circuit which outputs a carry signal based on the input signal, at least one of the plurality of clock signals, the first power source, and the second power source and an output circuit which outputs a gate signal based on the carry signal, at least one of the plurality of control clock signals, the first power source, and the second power source, and whether to output the gate signal of the output circuit is controlled based on at least one control clock signal.

According to one or more aspects of the present disclosure, a display device includes a display panel which includes a plurality of pixels and a first scan driver, a second scan driver, a third scan driver, and a fourth scan driver which output a first scan signal, a second scan signal, a third scan signal, and a fourth scan signal to the plurality of pixels, respectively, based on an input signal, a plurality of clock signals, a plurality of control clock signals, a first power source, and a second power source which has a voltage level lower than that of the first power source, in a first display period, each of the first scan signal, the second scan signal, the third scan signal, and the fourth scan signal has a gate-on level pulse, in a second display period which is different from the first display period, the third scan signal has a gate-on level pulse and the first scan signal, the second scan signal, and the fourth scan signal are maintained at a gate-off level, and at least some of the first scan driver, the second scan driver, and the fourth scan driver control signal levels of scan signals based on a same control clock signal, among the plurality of control clock signals.

Other detailed matters of the example embodiments are included in the detailed description and the drawings.

According to one or more aspects of the present disclosure, each stage of the gate driver may include a carry circuit which generates a carry signal and an output circuit which controls whether to output a gate signal.

Accordingly, according to one or more aspects of the present disclosure, an active area is freely divided in response to a display image without being restricted to a fixed area to control a driving frequency for each area.

Further, the driving frequency is controlled in response to the active area to improve a consumed power.

The effects according to one or more aspects of the present disclosure are not limited to the contents provided above, and other various effects are included in one or more aspects of the present disclosure.

Additional features, advantages, and aspects of the present disclosure are set forth in part in the description that follows and in part will become apparent from the present disclosure or may be learned by practice of the inventive concepts provided herein. Other features, advantages, and aspects of the present disclosure may be realized and attained by the descriptions provided in one or more aspects of the present disclosure, or derivable therefrom, and the claims hereof as well as the drawings. It is intended that all such features, advantages, and aspects be included within this description, be within the scope of the present disclosure, and be protected by the following claims. Nothing in this section should be taken as a limitation on those claims. Further features, advantages, and aspects are discussed below in conjunction with embodiments of the present disclosure.

It is to be understood that both the foregoing description and the following description of the present disclosure are examples, and are intended to provide further explanation of the disclosure as claimed.

### BRIEF DESCRIPTION OF THE DRAWINGS

The accompanying drawings, which are included to provide a further understanding of the present disclosure, are incorporated in and constitute a part of this present disclosure, illustrate aspects and embodiments of the present disclosure, and together with the description serve to explain principles and examples of the disclosure. In the drawings:
FIG. 1 is a block diagram illustrating a display device according to an example embodiment of the present disclosure;
FIGS. 2A and 2B are views illustrating an example of a display panel included in a display device of FIG. 1;
FIG. 3 is a circuit diagram illustrating an example of a pixel included in a display device of FIG. 1;
FIGS. 4A and 4B are waveform charts for explaining an example of an operation of a pixel of FIG. 3;
FIG. 5 is a block diagram illustrating a gate driver according to an example embodiment of the present disclosure;
FIG. 6 is a block diagram illustrating an example of a gate driver of FIG. 5;
FIG. 7 is a circuit diagram illustrating an example of a first stage included in a gate driver of FIG. 6;
FIG. 8 is a waveform chart for explaining an example of an operation of a first stage of FIG. 7;
FIGS. 9A to 9C are waveform charts for explaining an example of an operation of a gate driver of FIG. 6;
FIG. 10 is a block diagram illustrating another example of a gate driver of FIG. 5;
FIGS. 11A to 11C are waveform charts for explaining an example of an operation of a gate driver of FIG. 10;
FIG. 12 is a block diagram illustrating still another example of a gate driver of FIG. 5;
FIGS. 13A to 13C are waveform charts for explaining an example of an operation of a gate driver of FIG. 12;
FIG. 14 is a block diagram illustrating an example of a placement relationship of an emission driver, a plurality of scan drivers, and a plurality of signal lines included in a gate driver of FIG. 5;
FIG. 15 is a block diagram illustrating another example of a placement relationship of an emission driver, a plurality of scan drivers, and a plurality of signal lines included in a gate driver of FIG. 5;
FIG. 16 is a waveform chart for explaining another example of an operation of a pixel of FIG. 3; and
FIG. 17 is a waveform chart for explaining an example of an operation of a first scan driver and a fourth scan driver of FIG. 15.

Throughout the drawings and the detailed description, unless otherwise described, the same drawing reference numerals should be understood to refer to the same elements, features, and structures. The sizes, lengths, and thicknesses of layers, regions and elements, and depiction thereof may be exaggerated for clarity, illustration, and/or convenience.

### DETAILED DESCRIPTION

Advantages and characteristics of the present disclosure and a method of achieving the advantages and characteristics will be clear by referring to example embodiments described below in detail together with the accompanying drawings. However, the present disclosure is not limited to the example embodiments disclosed herein but will be implemented in various forms. The example embodiments are provided by way of example only so that those skilled in the art can fully understand the disclosures of the present disclosure and the scope of the present disclosure.

In the following description, when a detailed description of well-known methods, functions, structures or configurations may unnecessarily obscure aspects of the present disclosure, the detailed description thereof may have been omitted for brevity. Further, repetitive descriptions may be omitted for brevity. The progression of processing steps and/or operations described is a non-limiting example.

The sequence of steps and/or operations is not limited to that set forth herein and may be changed to occur in an order that is different from an order described herein, with the exception of steps and/or operations necessarily occurring in a particular order. In one or more examples, two operations in succession may be performed substantially concurrently, or the two operations may be performed in a reverse order or in a different order depending on a function or operation involved.

Unless stated otherwise, like reference numerals may refer to like elements throughout even when they are shown in different drawings. Unless stated otherwise, the same reference numerals may be used to refer to the same or substantially the same elements throughout the specification and the drawings. In one or more aspects, identical elements (or elements with identical names) in different drawings may have the same or substantially the same functions and properties unless stated otherwise. Names of the respective elements used in the following explanations are selected only for convenience and may be thus different from those used in actual products.

Advantages and features of the present disclosure, and implementation methods thereof, are clarified through the embodiments described with reference to the accompanying drawings. The present disclosure may, however, be embodied in different forms and should not be construed as limited to the embodiments set forth herein. Rather, these embodiments are examples and are provided so that this disclosure may be thorough and complete to assist those skilled in the art to understand the inventive concepts without limiting the protected scope of the present disclosure.

Shapes, dimensions (e.g., sizes, lengths, widths, heights, thicknesses, locations, radii, diameters, and areas), proportions, ratios, angles, numbers, the number of elements, and the like disclosed herein, including those illustrated in the drawings, are merely examples, and thus, the present disclosure is not limited to the illustrated details. It is, however, noted that the relative dimensions of the components illustrated in the drawings are part of the present disclosure.

When the term "comprise," "have," "include," "contain," "constitute," "made of," "formed of," "composed of," or the like is used with respect to one or more elements (e.g., layers, films, components, electrodes, structures, transistors, sections, members, parts, regions, areas, portions, steps, operations, and/or the like), one or more other elements may be added unless a term such as "only" or the like is used. The terms used in one or more aspects of the present disclosure are merely used in order to describe particular example embodiments, and are not intended to limit the scope of the present disclosure. The terms of a singular form may include plural forms unless the context clearly indicates otherwise. In one or more examples, unless the context clearly indicates otherwise, an element may be one or more elements; and an element may include a plurality of elements. The word "exemplary" is used to mean serving as an example or illustration. Embodiments are example embodiments. Aspects are example aspects. In one or more implementations, "embodiments," "examples," "aspects," and the like should not be construed to be preferred or advantageous over other implementations. An embodiment, an example, an example embodiment, an aspect, or the like may refer to one or more embodiments, one or more examples, one or more example embodiments, one or more aspects, or the like, unless stated otherwise. Further, the term "may" encompasses all the meanings of the term "can."

In one or more aspects, unless explicitly stated otherwise, an element, feature, or corresponding information (e.g., a level, range, dimension, size, or the like) is construed to include an error or tolerance range even where no explicit description of such an error or tolerance range is provided. An error or tolerance range may be caused by various factors (e.g., process factors, internal or external impact, noise, or the like). In interpreting a numerical value, the value is interpreted as including an error range unless explicitly stated otherwise.

When a positional relationship between two elements (e.g., layers, films, components, electrodes, structures, transistors, sections, members, parts, regions, areas, portions, and/or the like) are described using any of the terms such as "on," "on a top of," "upon," "on top of," "over," "under," "above," "upper," " "below," "lower," "beneath," "near," "close to," "adjacent to," "beside," "next to," "at or on a side of," and/or the like indicating a position or location, one or more other elements may be located between the two elements unless a more limiting term, such as "immediate(ly)," "direct(ly)," or "close(ly)," is used. For example, when an element and another element are described using any of the foregoing terms, this description should be construed as including a case in which the elements contact each other directly as well as a case in which one or more additional elements are disposed or interposed therebetween. Furthermore, the spatially relative terms such as the foregoing terms as well as other terms such as "front," "rear," "back," "left," "right," "top," "bottom," "upper," "lower," "up," "down," "column," "row," "vertical," "horizontal," "diagonal," and the like refer to an arbitrary frame of reference. For example, these terms may be used for an example understanding of a relative relationship between elements, including any correlation as shown in the drawings. However, embodiments of the disclosure are not limited thereby or thereto. The spatially relative terms are to be understood as terms including different orientations of the elements in use or in operation in addition to the orientation depicted in the drawings or described herein. For example, where a lower element or an element positioned under another element is overturned, then the element may be termed as an upper element or an element positioned above another element. Thus, for example, the term "under" or "beneath" may encompass, in meaning, the term "above" or "over." An example term "below" or the like, can include all directions, including directions of "below," "above" and diagonal directions. Likewise, an example term "above," "on" or the like can include all directions, including directions of "above," "on," "below" and diagonal directions.

In describing a temporal relationship, when the temporal order is described as, for example, "after," "following," "subsequent," "next," "before," "preceding," "prior to," or the like, a case that is not consecutive or not sequential may be included and thus one or more other events may occur therebetween, unless a more limiting term, such as "just," "immediate(ly)," or "direct(ly)," is used.

It is understood that, although the terms "first," "second," and the like may be used herein to describe various elements (e.g., layers, films, components, electrodes, structures, transistors, sections, members, parts, regions, areas, portions, steps, operations, and/or the like), these elements should not be limited by these terms, for example, to any particular order, precedence, or number of elements. These terms are used only to distinguish one element from another. For example, a first element may denote a second element, and, similarly, a second element may denote a first element, without departing from the scope of the present disclosure. Furthermore, the first element, the second element, and the like may be arbitrarily named according to the convenience of those skilled in the art without departing from the scope of the present disclosure. For clarity, the functions or structures of these elements (e.g., the first element, the second element, and the like) are not limited by ordinal numbers or the names in front of the elements. Further, a first element may include one or more first elements. Similarly, a second element or the like may include one or more second elements or the like.

In describing elements of the present disclosure, the terms "first," "second," "A," "B," "(a)," "(b)," or the like may be used. These terms are intended to identify the corresponding element(s) from the other element(s), and these are not used to define the essence, basis, order, or number of the elements.

The expression that an element (e.g., layer, film, component, electrode, structure, transistor, section, member, part, region, area, portion, or the like) "is engaged" with another element may be understood, for example, as that the element may be either directly or indirectly engaged with the another element. The term "is engaged" or similar expressions may refer to a term such as "covers," "is in contact," "overlaps," "crosses," "intersects," "is connected," "is coupled," "is joined," "is attached," "is adhered," "is combined," "is linked," "is provided," "is disposed," "interacts," or the like. The engagement may involve one or more intervening elements disposed or interposed between the element and the another element, unless otherwise specified. Further, the element may be engaged at least partially or entirely (or completely) with the another element, unless otherwise specified. Further, the element may be included in at least one of two or more elements that are engaged with each other. Similarly, the another element may be included in at least one of two or more elements that are engaged with each other. When the element is engaged with the another element, at least a portion of the element may be engaged with at least a portion of the another element. The term "with another element" or similar expressions may be understood as "another element," or "with, to, in, or on another element," as appropriate by the context. Similarly, the term "with each other" may be understood as "each other," or "with, to, or on each other," as appropriate by the context.

The phrase "through" may be understood, for example, to be at least partially through or entirely through.

The term "at least one" should be understood as including any and all combinations of one or more of the associated listed items. For example, each of the phrases "at least one of a first item, a second item, or a third item" and "at least one of a first item, a second item, and a third item" may represent (i) a combination of items provided by two or more of the first item, the second item, and the third item or (ii) only one of the first item, the second item, or the third item. Further, at least one of a plurality of elements can represent (i) one element of the plurality of elements, (ii) some elements of the plurality of elements, or (iii) all elements of the plurality of elements. Further, "at least some," "some," "at least some portions," "at least some parts," "at least a portion," "at least one or more portions," "at least a part," "at least one or more parts," "at least some elements," "one or more," or the like of a plurality of elements can represent (i) one element of the plurality of elements, (ii) a portion (or a part) of the plurality of elements, (iii) one or more portions (or parts) of the plurality of elements, (iv) one or more elements of the plurality of elements, (v) multiple elements of the plurality of elements, or (vi) all of the plurality of elements. Moreover, "at least some," "some," "at least some portions," "at least some parts," "at least a portion," "at least one or more portions," "at least a part," "at least one or more parts," or the like of an element can represent (i) a portion (or a part) of the element, (ii) one or more portions (or parts) of the element, (iii) the element, or (iv) all portions of the element.

The expression of a first element, a second elements "and/or" a third element should be understood as any one of the first, second and third elements or as any or all combinations of the first, second and third elements. Similar interpretations apply to the use of "and/or" with two elements or with more than three elements. By way of example, A, B and/or C may refer to only A; only B; only C; any of A, B, and C (e.g., A, B, or C); some combination of A, B, and C (e.g., A and B; A and C; or B and C); or all of A, B, and C. Furthermore, an expression "A/B" may be understood as A and/or B. For example, an expression "A/B" may refer to only A; only B; A or B; or A and B.

In one or more aspects, the terms "between" and "among" may be used interchangeably simply for convenience unless stated otherwise. For example, an expression "between a plurality of elements" may be understood as among a plurality of elements. In another example, an expression "among a plurality of elements" may be understood as between a plurality of elements. In one or more examples, the number of elements may be two. In one or more examples, the number of elements may be more than two. Furthermore, when an element is referred to as being "between" at least two elements, the element may be the only element between the at least two elements, or one or more intervening elements may also be present.

In one or more aspects, the phrases "each other" and "one another" may be used interchangeably simply for convenience unless stated otherwise. For example, an expression "different from each other" may be understood as being different from one another. In another example, an expression "different from one another" may be understood as being different from each other. In one or more examples, the number of elements involved in the foregoing expression may be two. In one or more examples, the number of elements involved in the foregoing expression may be more than two.

In one or more aspects, the phrases "one or more among" and "one or more of" may be used interchangeably simply for convenience unless stated otherwise. In one or more aspects, unless stated otherwise, the term "nth" may refer to "nnd" (e.g., 2nd where n is 2), or "nrd" (e.g., 3rd where n is 3), and n may be a natural number or a whole number.

The term "or" means "inclusive or" rather than "exclusive or." That is, unless otherwise stated or clear from the context, the expression that "x uses a or b" means any one of natural inclusive permutations. For example, "a or b" may mean "a," "b," or "a and b." For example, "a, b or c" may mean "a," "b," "c," "a and b," "b and c," "a and c," or "a, b and c."

A phrase "substantially the same" or "nearly the same" may indicate a degree of being considered as being equivalent to each other taking into account minute differences due to errors in the manufacturing process.

Features of various embodiments of the present disclosure may be partially or entirely coupled to or combined with each other, may be technically associated with each other, and may be variously operated, linked or driven together in various ways. Embodiments of the present disclosure may be implemented or carried out independently of each other or may be implemented or carried out together in a co-dependent or related relationship. In one or more aspects, the components of each apparatus and device according to various embodiments of the present disclosure are operatively coupled and configured.

Unless otherwise defined, the terms (including technical and scientific terms) used herein have the same meaning as commonly understood by one of ordinary skill in the art to which example embodiments belong. It is further understood that terms, such as those defined in commonly used dictionaries, should be interpreted as having a meaning that is, for example, consistent with their meaning in the context of the relevant art and should not be interpreted in an idealized or overly formal sense unless expressly defined otherwise herein. For example, the term "part" or "unit" may apply, for example, to a separate circuit, component or structure, an integrated circuit, a computational block of a circuit device, or a structure configured to perform a described function as should be understood by one of ordinary skill in the art.

The terms used herein have been selected as being general in the related technical field; however, there may be other terms depending on the development and/or change of technology, convention, preference of technicians, and so on. Therefore, the terms used herein should not be understood as limiting technical ideas, but should be understood as examples of the terms for describing example embodiments.

Further, in a specific case, a term may be arbitrarily selected by an applicant, and in this case, the detailed meaning thereof is described herein. Therefore, the terms used herein should be understood based on not only the name of the terms, but also the meaning of the terms and the content hereof.

In the following description, various example embodiments of the present disclosure are described in more detail with reference to the accompanying drawings. With respect to reference numerals to elements of each of the drawings, the same or similar elements may be illustrated in other drawings, and like reference numerals may refer to like or similar elements unless stated otherwise. The same or similar elements may be denoted by the same reference numerals even if they are depicted in different drawings. Repetitive descriptions of the same or similar elements may be omitted for brevity, and the descriptions provided for elements in one or more figures may also apply to elements in other figures that use the same or similar reference numerals unless stated otherwise. In addition, for the convenience of description, a scale, dimension, size, and thickness of each of the elements illustrated in the accompanying drawings may be different from an actual scale, dimension, size, and thickness, and thus, embodiments of the present disclosure are not limited to a scale, dimension, size, and thickness illustrated in the drawings.

In description of flow of a signal, for example, when a signal is provided (e.g., transferred or transmitted) from a node A to a node B, this may include a case where the signal is provided from the node A to the node B via one or more nodes unless a phrase such as "immediately provided," "directly provided" or the like is used.

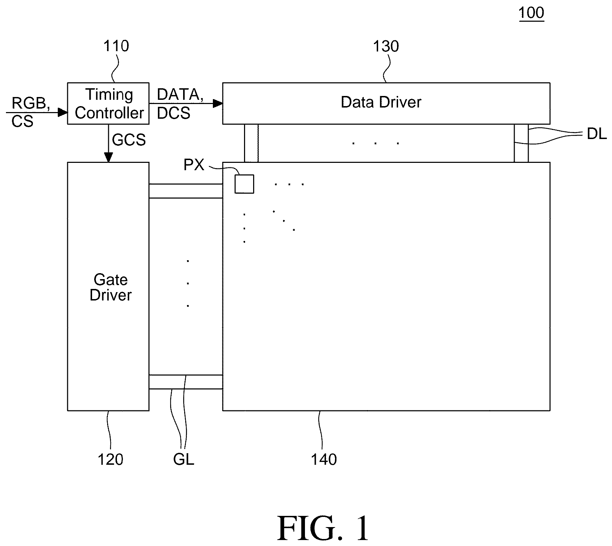

FIG. 1 is a block diagram illustrating a display device according to an example embodiment of the present disclosure.

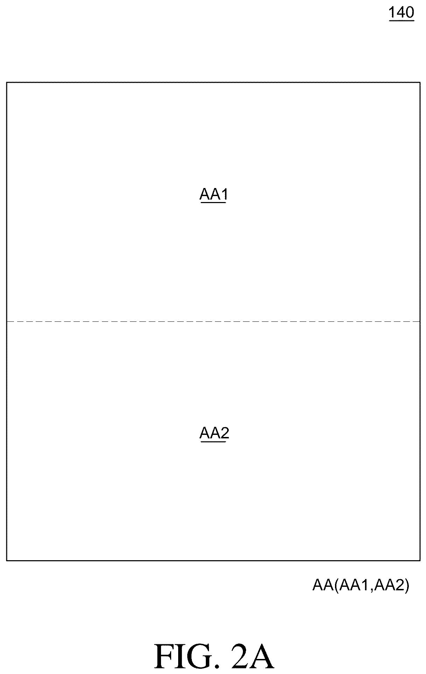

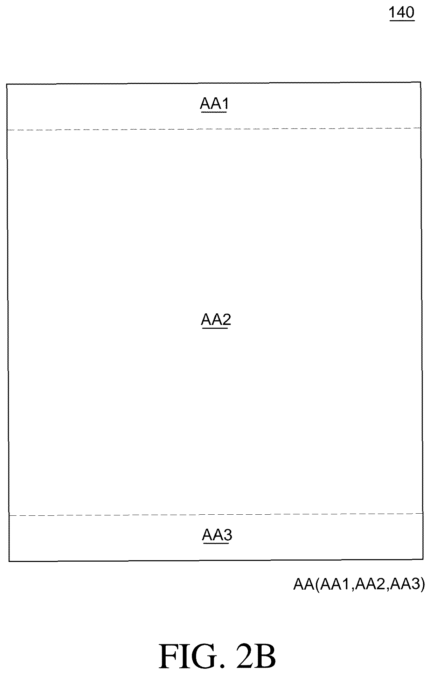

FIGS. 2A and 2B are views illustrating an example of a display panel included in a display device of FIG. 1.

Referring to FIG. 1, a display device 100 according to an example embodiment of the present disclosure may include a timing controller 110, a gate driver 120, a data driver 130, and a display panel 140.

The display panel 140 may generate images to be provided to the user. For example, the display panel 140 may include an active area in which a plurality of pixels PX each including a pixel circuit is disposed and a non-active area other than the active area.

Each of the plurality of pixels PX is connected to a corresponding gate line GL and a corresponding data line DL to display images in response to a gate signal supplied to the gate line GL and a data signal supplied to the data line DL.

According to the example embodiment, the active area of the display panel 140 may be partitioned into a plurality of areas. For example, the active area may include a plurality of sub active areas. For example, further referring to FIG. 2A, the active area AA of the display panel 140 may be partitioned into a first sub active area AA1 and a second sub active area AA2.

The first sub active area AA1 and the second sub active area AA2 included in the active area AA may include at least one pixel PX. For example, at least one pixel PX may be disposed on each of the first sub active area AA1 and the second sub active area AA2.

In one example embodiment, the active area AA is partitioned into sub active areas having the same size and the first sub active area AA1 and the second sub active area AA2 may include the same number of pixels PX. However, this is illustrative and the first sub active area AA1 and the second sub active area AA2 included in the active area AA share one or more pixels PX and/or the number of pixels PX of any one sub active area may be larger than the number of pixels PX of another sub active area.

However, for the convenience of description, in FIG. 2A, it has been described that the active area AA is partitioned into two sub active area, but the example embodiment of the present disclosure is not limited thereto and the active area AA may be partitioned into three or more sub active areas. For example, as illustrated in FIG. 2B, the active area AA may be partitioned into a second sub active area AA2, a first sub active area AA1 and a third sub active area AA3 disposed on both sides of the second sub active area AA2.

Referring to FIG. 1 again, the timing controller 110 may control the gate driver 120 and the data driver 130 based on input image RGB and an input control signal CS supplied from the outside (for example, a host system). For example, the input control signal CS may include timing signals, such as a horizontal synchronization signal, a vertical synchronization signal, a data enable signal, and a clock signal and the timing controller 110 may generate a gate control signal GCS and a data control signal DCS based on the input control signal CS. The gate control signal GCS is supplied to the gate driver 120 and the data control signal DCS is supplied to the data driver 130.

Further, the timing controller 110 realigns an input image RGB with a digital video data format in accordance with a resolution of the display panel 140 to generate image data DATA and provide the image data to the data driver 130.

The gate driver 120 generates a gate signal based on the gate control signal GCS and may output the gate signal to the plurality of gate lines GL. For example, the gate driver 120 may sequentially output the gate signal to the plurality of gate lines GL in the unit of pixel rows. The gate control signal GCS may include a start signal and a plurality of clock signals for generating gate signals.

In the example embodiment, the gate driver 120 may generate a scan signal and an emission signal based on the gate control signal GCS. For example, the gate driver 120 may include at least one scan driver and at least one emission driver. The scan driver generates a scan signal in a row sequential manner to drive at least one or more scan lines connected to each pixel row to supply the scan signal to the plurality of scan lines. The emission driver generates an emission signal in a row sequential manner to drive at least one or more emission signal lines connected to each pixel row to supply the emission signal to the plurality of emission signal lines.

The data driver 130 converts digital image data DATA supplied from the timing controller 110 into an analog data signal based on the data control signal DCS to supply the converted analog data signal to the plurality of data lines DL.

The display device 100 according to the example embodiment of the present disclosure may display the images at various driving frequencies according to a driving condition. Here, the driving frequency may refer to a frequency at which the data signal is substantially written in a driving transistor included in the pixel PX. For example, the driving frequency may refer to a frequency at which the display image is reproduced for one second. That is, the display device 100 may display images in response to various driving frequencies. In the meantime, in one or more aspects of the present disclosure, the driving frequency may also be referred to as an image refresh rate, a screen refresh rate, or a screen scan rate.

In one example embodiment, in response to the driving frequency of the display device 100, an output frequency of the data driver 130 for one horizontal line, for example, one pixel row and/or an output frequency of the gate driver 120 which outputs the gate signal may be determined. For example, a driving frequency for driving a moving image is a frequency of approximately 60 Hz or higher, for example, 60 Hz, 80 Hz, 96 Hz, 120 Hz, or 240 Hz, which is a relatively high frequency. As another example, a driving frequency for driving a still image is approximately 30 Hz or lower, for example, 30 Hz, 10 Hz, or 1 Hz, which is a relatively low frequency. Therefore, the display device 100 may adjust an output frequency of the gate driver 120 for one horizontal line, for example, one pixel row and an output frequency of the data driver 130 corresponding thereto in accordance to the driving condition.

According to the example embodiment, the display device 100 may independently drive a plurality of sub active areas included in the active area AA. For example, according to the driving mode of the display device 100, the display device 100 drives a plurality of sub active areas included in the active area AA at the same driving frequency or may drive at least some of the plurality of sub active areas at different driving frequencies.

In the meantime, when the display device 100 controls the driving frequency for each sub active area of the active area AA, the corresponding sub active areas may not be fixed areas. That is, the display device 100 according to the example embodiment of the present disclosure divides the active area AA into two or more sub active areas with respect to a position where the driving frequency is to be divided in response to the display image, for example, a horizontal line in which the driving frequency is to be divided. Further, each sub active area may be driven at different driving frequencies.

As described above, the display device 100 according to the example embodiment of the present disclosure freely divides the active area AA of the display device 100 in response to the display image without being restricted to a fixed area, to control the driving frequency for each area. Accordingly, the driving frequency is controlled for each area in response to the display image to improve a consumed power.

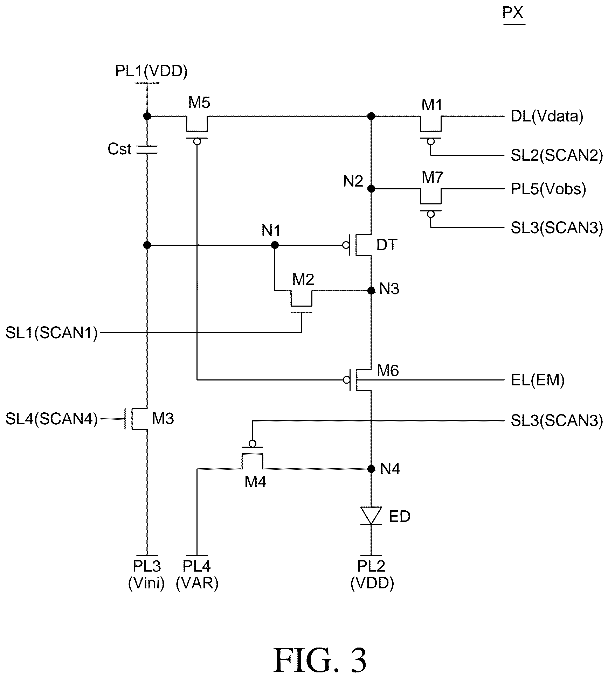

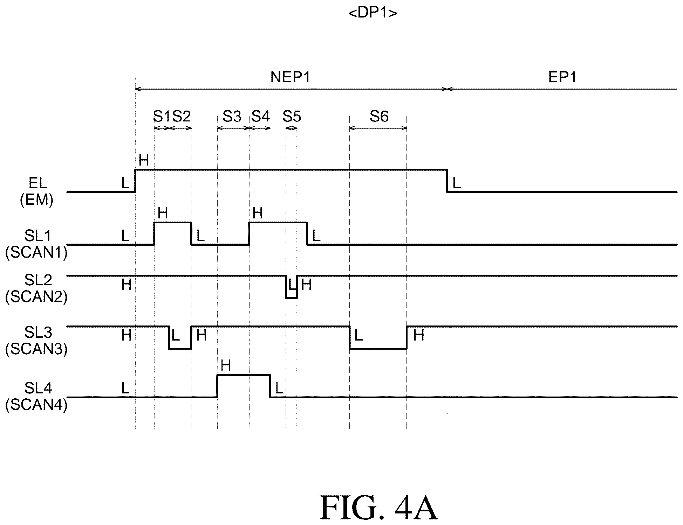

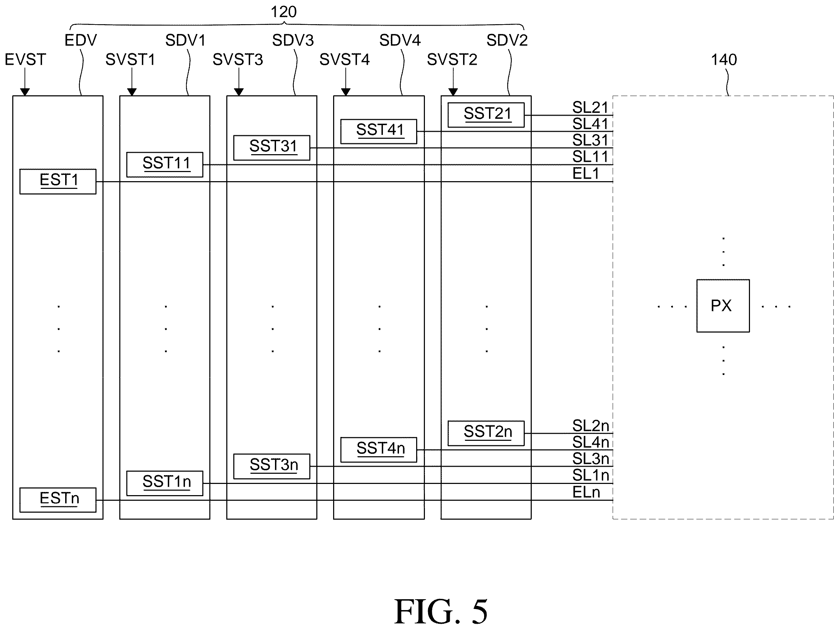

Hereinafter, a pixel PX and a driving method thereof will be described in more detail with reference to FIGS. 3 to 4B and a driving method which allows a display device 100 according to example embodiments of the present disclosure to display an image at various driving frequencies will be described in more detail with reference to FIGS. 5 to 17.

FIG. 3 is a circuit diagram illustrating an example of a pixel included in a display device of FIG. 1.

Referring to FIG. 3, the pixel PX may include a light emitting diode ED, a driving transistor DT, a plurality of switching transistors M1 to M7, and a storage capacitor Cst.

The driving transistor DT may be connected between a first power line PL1 which supplies a high potential power voltage VDD and a second power line PL2 which supplies a low potential power voltage VSS. The driving transistor DT may control a driving current applied to the light emitting diode ED in accordance with a source-gate voltage. For example, the driving transistor DT may control a driving current which flows from the first power line PL1 which supplies the high potential power voltage VDD to the second power line PL2 which supplies the low potential power voltage VSS via the light emitting diode ED in response to the voltage of a first node N1, which is a gate electrode. To this end, the high potential power voltage VDD may be set to be higher than the low potential power voltage VSS. For example, the high potential power voltage VDD is a positive voltage and the low potential power voltage VSS is a negative voltage.

The first switching transistor M1 may be connected between the data line DL which supplies a data signal Vdata and a first electrode of the driving transistor DT, for example, a second node N2 which is a source electrode. The gate electrode of the first switching transistor M1 may be connected to the second scan line SL2. When a second scan signal SCAN2 is supplied to the second scan line SL2, a first switching transistor M1 is turned on to electrically connect the data line DL and the second node N2.

A second switching transistor M2 may be connected between the second electrode of the driving transistor DT, for example, a third node N3 which is a drain electrode, and the first node N1 which is a gate electrode. The gate electrode of the second switching transistor M2 may be connected to the first scan line SL1. When the first scan signal SCAN1 is supplied to the first scan line SL1, the second switching transistor M2 is turned on to electrically connect the gate electrode and the drain electrode of the driving transistor DT, for example, the first node N1 and the third node N3. When the second switching transistor M2 is turned on, the driving transistor DT may be connected in a diode form.

A third switching transistor M3 may be connected between the first node N1 and a third power line PL3 which supplies a first initialization voltage Vini. A gate electrode of the third switching transistor M3 may be connected to a fourth scan line SL4. When a fourth scan signal SCAN4 is supplied to the fourth scan line SL4, the third switching transistor M3 is turned on to supply the first initialization voltage Vini to the first node N1. In this case, the gate electrode of the driving transistor DT which is the first node N1 may be initialized to the first initialization voltage Vini. To this end, the first initialization voltage Vini may be set to a voltage which is lower than a lowest level of the data signal Vdata which is supplied to the data line DL.

A fourth switching transistor M4 may be connected between a fourth node N4 which is a first electrode of the light emitting diode ED and the fourth power line PL4 which supplies a second initialization voltage VAR. A gate electrode of the fourth switching transistor M4 may be connected to a third scan line SL3. When a third scan signal SCAN3 is supplied to the third scan line SL3, the fourth switching transistor M4 is turned on to supply the second initialization voltage VAR to the fourth node N4 which is the first electrode of the light emitting diode ED. In this case, the parasitic capacitor of the light emitting diode ED may be discharged. Accordingly, unintended minute emission may be suppressed to improve a black expression ability of the pixel PX.

In the meantime, a voltage level of the first initialization voltage Vini and a voltage level of the second initialization voltage VAR may be different from each other. That is, a voltage which initializes the first node N1 and a voltage which initializes the fourth node N4 may be set to be different from each other.

When the first initialization voltage Vini which is supplied to the first node N1 is significantly low in the low-frequency driving in which a length of one frame period is increased, a robust on-bias is applied to the driving transistor DT so that a threshold voltage of the driving transistor DT in the corresponding frame period may be shifted. Such a hysteresis characteristic may cause a flickering phenomenon in the low frequency driving. Accordingly, in the display device 100 which is driven at the low frequency, the first initialization voltage Vini which is higher than the low potential power voltage VSS may be required.

However, when a voltage level of the second initialization voltage VAR which is supplied to the fourth node N4 to initialize the light emitting diode ED is higher than a predetermined reference, the voltage of the parasitic capacitor of the light emitting diode ED is not discharged, but may be charged. Accordingly, the voltage level of the second initialization voltage VAR should be sufficiently low to discharge the voltage of the parasitic capacitor of the light emitting diode ED. For example, in consideration of the threshold voltage of the light emitting diode ED, a voltage level of the second initialization voltage VAR may be set to be lower than a sum of a threshold voltage of the light emitting diode ED and the low potential power voltage VSS.

However, this is illustrative so that the voltage level of the first initialization voltage Vini and the voltage level of the second initialization voltage VAR may be set in various levels. For example, the voltage level of the first initialization voltage Vini and the voltage level of the second initialization voltage VAR may be substantially the same.

A fifth switching transistor M5 may be connected between the first power line PL1 and the second node N2. A gate electrode of the fifth switching transistor M5 may be connected to an emission control line EL. When the emission control signal EM is supplied to the emission control line EL, the fifth switching transistor M5 is turned off and in the other case, may be turned on. When the fifth switching transistor M5 is turned on, the second node N2 may be electrically connected to the first power line PL1.

A sixth switching transistor M6 may be connected between the third node N3 which is the drain electrode of the driving transistor DT and the first electrode of the light emitting diode ED, for example, the fourth node N4. A gate electrode of the sixth switching transistor M6 may be connected to the emission control line EL. The sixth switching transistor M6 may be controlled in the substantially same manner as the fifth switching transistor M5. When the sixth switching transistor M6 is turned on, the third node N3 and the fourth node N4 may be electrically connected.

A seventh switching transistor M7 may be connected between the second node N2 and a fifth power line PL5 which supplies a bias voltage Vobs. A gate electrode of the seventh switching transistor M7 may be connected to a third scan line SL3. When a third scan signal SCAN3 is supplied to the third scan line SL3, the seventh switching transistor M7 is turned on to supply the bias voltage Vobs to the second node N2 which is the source electrode of the driving transistor DT.

In the example embodiment, the bias voltage Vobs may have a level which is similar to a voltage level of a black grayscale of data signal Vdata. For example, the bias voltage Vobs has a voltage level of approximately 5 to 7 V, but it is illustrative and the voltage level of the bias voltage Vobs is not limited thereto.

Accordingly, the seventh switching transistor M7 is turned on to apply a predetermined high voltage to the source electrode of the driving transistor DT. At this time, if the second switching transistor M2 is in a turned-off state, the driving transistor DT may be in an on-bias state.

Here, as the bias voltage Vobs is periodically supplied to the second node N2, the bias state of the driving transistor DT is periodically changed and a threshold voltage characteristic of the driving transistor DT may be changed. Accordingly, the characteristic of the driving transistor DT may be suppressed from being fixed to a specific state in the low-frequency driving to be degraded.

The storage capacitor Cst may be connected between the first power line PL1 and the first node N1. One electrode of the storage capacitor Cst is connected to the first power line PL1 so that the high potential power voltage VDD which is a constant voltage may be continuously supplied to one electrode of the storage capacitor Cst. Accordingly, a voltage of the first node N1 is not affected by another parasitic capacitor and may be maintained at a voltage level of a voltage which is supplied to the first node N1. That is, the storage capacitor Cst may store a voltage applied to the first node N1.

In the meantime, the driving transistor DT, the first switching transistor M1, the fourth switching transistor M4, the fifth switching transistor M5, the sixth switching transistor M6, and the seventh switching transistor M7 are configured by polysilicon semiconductor transistors, for example, PMOS transistors. The second switching transistor M2 and the third switching transistor M3 are configured by oxide semiconductor transistors, for example, NMOS transistors, but the present disclosure is not limited thereto.

The first electrode of the light emitting diode ED, for example, the anode electrode is connected to the fourth node N4 and the second electrode, for example, the cathode electrode may be connected to the second power line PL2 which supplies the low potential power voltage VSS. The light emitting diode ED may generate light with a predetermined luminance in response to a driving current supplied from the driving transistor DT.

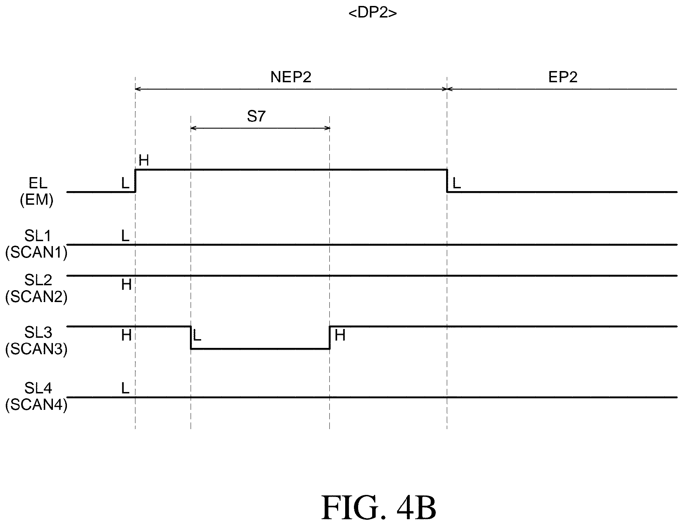

FIGS. 4A and 4B are waveform charts for explaining an example of an operation of a pixel of FIG. 3.

For example, FIG. 4A illustrates an example of signals supplied to the pixel PX in a first display period DP1 and FIG. 4B illustrates an example of signals supplied to the pixel PX in a second display period DP2.

Referring to FIGS. 3, 4A, and 4B, the pixel PX may be driven by the first display period DP1 and the second display period DP2.

In the variable frequency driving in which the frame frequency is controlled, one frame period may include the first display period DP1. Further, the second display period DP2 may proceed at least once according to the frame frequency. For example, in one frame period, after driving the display device 100 as the first display period DP1, the display device 100 may be driven by the second display period DP2.

The first display period DP1 may include a first non-emission period NEP1 and a first emission period EP1. The second display period DP2 may include a second non-emission period NEP2 and a second emission period EP2. For example, the first non-emission period NEP1 and the second non-emission period NEP2 may refer to periods in which a path of a driving current flowing from the first power line PL1 to the second power line PL2 via the light emitting diode ED is blocked. The first emission period EP1 and the second emission period EP2 may refer to periods in which the path of the driving current is formed so that the light emitting diode ED emits light based on the driving current.

The first display period DP1 may include a period in which a data signal Vdata corresponding to the display image is written in the pixel PX. For example, during the first non-emission period NEP1 of the first display period DP1, the data signal Vdata may be written.

During the second display period DP2, the data signal Vdata is not supplied. Further, in order to control the driving transistor DT of the pixel PX in the on-bias state and initialize the light emitting diode ED, the third scan signal SCAN3 may be supplied to the third scan line SL3.

As illustrated in FIGS. 4A and 4B, the first non-emission period NEP1 includes first to sixth driving periods S1 to S6 and the second non-emission period NEP2 may include a seventh driving period S7.

In one example embodiment, the first scan signal SCAN1, the second scan signal SCAN2, and the fourth scan signal SCAN4 may be supplied only during the first non-emission period NEP1. In the meantime, the first scan signal SCAN1 may be supplied plural times for the first non-emission period NEP1.

In one example embodiment, the third scan signal SCAN3 may be supplied during the first non-emission period NEP1 and the second non-emission period NEP2. Further, as illustrated in FIGS. 4A and 4B, the third scan signal SCAN3 is supplied plural times during the first non-emission period NEP1 and may be supplied once during the second non-emission period NEP2. However, the example embodiment of the present disclosure is not limited thereto and for example, the third scan signal SCAN3 may be supplied plural times during the second non-emission period NEP2.

In the meantime, the first scan signal SCAN1, the second scan signal SCAN2, the third scan signal SCAN3, and the fourth scan signal SCAN4 are supplied from at least one scan driver included in the gate driver 120 and the emission control signal EM may be supplied from at least one emission driver included in the gate driver 120.

The emission control signal EM may be maintained at a gate-off level, for example, a high level H, during the first non-emission period NEP1 and the second non-emission period NEP2. Accordingly, during the first non-emission period NEP1 and the second non-emission period NEP2, the fifth switching transistor M5 and the sixth switching transistor M6 are maintained at a turned-off state respectively to block a path of a driving current flowing from the first power line PL1 to the second power line PL2 via the light emitting diode ED.

First, the first display period DP1 will be described with reference to FIGS. 3 and 4. During the first driving period S1, the first scan signal SCAN1 is supplied to the first scan line SL1 to turn on the second switching transistor M2. Accordingly, the gate electrode and the drain electrode of the driving transistor DT are connected to form a diode connection.

Thereafter, in the second driving period S2, the first scan signal SCAN1 is supplied to the first scan line SL1 and the third scan signal SCAN3 may be supplied to the third scan line SL3. For example, the supplying of the first scan signal SCAN1 supplied during the first driving period S1 may be maintained until the second driving period S2. That is, in the first driving period S1 and the second driving period S2, after the second switching transistor M2 is turned on, the fourth switching transistor M4 and the seventh switching transistor M7 may be turned on.

Accordingly, in a state in which the gate electrode and the drain electrode of the driving transistor DT are connected, if the seventh switching transistor M7 is turned on, the bias voltage Vobs may be transmitted to the first node N1 through the second node N2. For example, a voltage difference of the second node N2 and the first node N1 may be reduced to a threshold voltage level of the driving transistor DT. Accordingly, in the second driving period S2, a magnitude of the gate-source voltage of the driving transistor DT may become very low. For example, the driving transistor DT may be set in an off-bias state. Therefore, in order to suppress unintended increase of luminance due to the bias voltage Vobs supplied before writing the data signal in the second driving period S2, the first scan signal SCAN1 and the third scan signal SCAN3 may be controlled to be supplied to turn on the seventh switching transistor M7 in the turned-on state of the second switching transistor M2.

Further, the fourth switching transistor M4 may be turned on by the third scan signal SCAN3 supplied in the second driving period S2. Accordingly, the second initialization voltage VAR may be supplied to the first electrode of the light emitting diode ED, for example, the fourth node N4. Accordingly, the first electrode of the light emitting diode ED is initialized based on the voltage level of the second initialization voltage VAR to discharge the parasitic capacitance of the light emitting diode ED. By doing this, a black expression ability of the pixel PX may be improved.

Thereafter, in the third driving period S3, the fourth scan signal SCAN4 is supplied to the fourth scan line SL4 to turn on the third switching transistor M3. When the third switching transistor M3 is turned on, the first initialization voltage Vini may be supplied to the gate electrode of the driving transistor DT. Accordingly, the gate voltage of the driving transistor DT may be initialized based on the first initialization voltage Vini. Accordingly, a robust on-bias is applied to the driving transistor DT and a hysteresis characteristic may be changed. For example, a threshold voltage may be shifted.

In the meantime, the supplying of the fourth scan signal SCAN4 may be maintained even after the third driving period S3. For example, as illustrated in FIG. 4A, the fourth scan signal SCAN4 may maintain a gate-on level, for example, a high level H during the fourth driving period S4 after the third driving period S3.

Thereafter, in the fourth driving period S4, the first scan signal SCAN1 is supplied to the first scan line SL1 to turn on the second switching transistor M2 again.

Thereafter, in the fifth driving period S5, the second scan signal SCAN2 may be supplied to the second scan line SL2 by overlapping at least a part of a period in which the first scan signal SCAN1 is supplied. Accordingly, the first switching transistor M1 is turned on by the second scan signal SCAN2 and the data signal Vdata may be supplied to the second node N2.

Here, the driving transistor DT is connected in a diode form by the turned-on second switching transistor M2 so that the data signal writing and the threshold voltage compensation may be performed together. In the meantime, before supplying the second scan signal SCAN2 and after stopping supplying of the second scan signal SCAN2, the first scan signal SCAN1 is supplied so that the threshold voltage of the driving transistor DT may be compensated for a sufficient time.

Thereafter, in the sixth driving period S6, the third scan signal SCAN3 is supplied to the third scan line SL3 again to turn on the fourth switching transistor M4 and the seventh switching transistor M7. The seventh switching transistor M7 is turned on so that the bias voltage Vobs may be supplied to the first node N1.

In the meantime, the influence of the robust on-bias applied during the third driving period S3 may be removed by the writing of the data signal Vdata and the compensation of the threshold voltage. For example, a voltage difference of the gate voltage and the source voltage of the driving transistor DT may be significantly reduced by compensating for the threshold voltage in the first scan signal SCAN1 supplying period including the fourth driving period S4 and the fifth driving period S5. By doing this, the characteristic of the driving transistor DT is changed again and the driving current of the first emission period EP1 is increased or the lifting in the black grayscale may be visible.

In order to suppress such a characteristic change, in the sixth driving period S6, the seventh switching transistor M7 may be turned on by supplying the third scan signal SCAN3. Accordingly, the bias voltage Vobs is supplied to the first electrode, for example, a source electrode, of the driving transistor DT in the sixth driving period S6 so that the driving transistor DT may be set to an on-bias state.

Further, the second initialization voltage VAR may be supplied to the first electrode of the light emitting diode ED by the fourth switching transistor M4 which is turned on in the sixth driving period S6. Accordingly, the first electrode of the light emitting diode ED may be initialized based on the voltage level of the second initialization voltage VAR.

After the sixth driving period S6, the supplying of the emission control signal EM to the emission control line EL is stopped, for example, the emission control signal EM is shifted to the low level L so that the first non-emission period NEP1 ends and the first emission period EP1 may proceed. In this case, the fifth switching transistor M5 and the sixth switching transistor M6 may be turned on.

In the first emission period EP1, a driving current corresponding to a data signal Vdata written in the fifth driving period S5 is supplied to the light emitting diode ED and the light emitting diode ED may emit light based on the driving current.

Next, the second display period DP2 will be described with reference to FIGS. 3 and 4B. The second display period DP2 may include the second non-emission period NEP2 and the second emission period EP2 and the second non-emission period NEP2 may include a seventh driving period S7.

In one example embodiment, a waveform of the emission control signal EM in the second display period DP2 may be substantially the same as a waveform of the emission control signal EM in the first display period DP1.

In the example embodiment, in the second display period DP2, the first scan signal SCAN1, the second scan signal SCAN2, and the fourth scan signal SCAN4 may not be supplied. For example, in the second display period DP2, the first scan signal SCAN1 and the fourth scan signal SCAN4 are maintained at a gate-on level, for example, a low level L and the second scan signal SCAN2 may be maintained at a gate-off level, for example, a high level H. Accordingly, in the second display period DP2, the first switching transistor M1, the second switching transistor M2, and the third switching transistor M3 may be maintained in a turn-off state.

In the seventh driving period S7 of the second non-emission period NEP2, the third scan signal SCAN3 is supplied to turn on the fourth switching transistor M4 and the seventh switching transistor M7. Accordingly, the second initialization voltage VAR is supplied to the first electrode of the light emitting diode ED by the turned-on fourth switching transistor M4 to initialize the first electrode of the light emitting diode ED based on the second initialization voltage VAR. The bias voltage Vobs may be supplied to the source electrode of the driving transistor DT, for example, the first node N1 by the turned-on seventh switching transistor M7.

After the seventh driving period S7, the supplying of the emission control signal EM to the emission control line EL is stopped, for example, the emission control signal EM is shifted to the low level L so that the second non-emission period NEP2 ends and the second emission period EP2 may proceed. In this case, the fifth switching transistor M5 and the sixth switching transistor M6 may be turned on.

In the second emission period EP2, a driving current corresponding to a data signal Vdata written in the first display period DP1 is supplied to the light emitting diode ED and the light emitting diode ED may emit light based on the driving current.

In the meantime, in FIG. 4B, it is described that the third scan signal SCAN3 is supplied to the third scan line SL3 once, but the example embodiment of the present disclosure is not limited thereto and for example, in the second non-emission period NEP2, the third scan signals SCAN3 may be supplied plural times.

FIG. 5 is a block diagram illustrating a gate driver according to an example embodiment of the present disclosure.

In the meantime, in FIG. 5, the display panel 140 which has been described with reference to FIG. 1 and the pixel PX disposed in the display panel 140 are illustrated together with the gate driver 120.

Referring to FIGS. 1 to 5, the gate driver 120 may include a first scan driver SDV1, a second scan driver SDV2, a third scan driver SDV3, a fourth scan driver SDV4, and an emission driver EDV.

A gate control signal GCS which is supplied from the timing controller 110 to the gate driver 120 may include a first scan start signal SVST1, a second scan start signal SVST2, a third scan start signal SVST3, a fourth scan start signal SVST4, and an emission start signal EVST. The first scan start signal SVST1, the second scan start signal SVST2, the third scan start signal SVST3, the fourth scan start signal SVST4, and the emission start signal EVST may be supplied to the first scan driver SDV1, the second scan driver SDV2, the third scan driver SDV3, the fourth scan driver SDV4, and the emission driver EDV, respectively.

Widths and supplying timings of the first scan start signal SVST1, the second scan start signal SVST2, the third scan start signal SVST3, the fourth scan start signal SVST4, and the emission start signal EVST may be determined according to a driving condition and a frame frequency of the pixel PX. For example, the first scan signal SCAN1, the second scan signal SCAN2, the third scan signal SCAN3, the fourth scan signal SCAN4, and the emission control signal EM may be output based on the first scan start signal SVST1, the second scan start signal SVST2, the third scan start signal SVST3, the fourth scan start signal SVST4, and the emission start signal EVST, respectively.

The first scan driver SDV1 may sequentially supply the first scan signal SCAN1 to a plurality of first scan lines S11 to S1n in response to the first scan start signal SYST1 (here, n is an integer larger than 0). For example, the first scan driver SDV1 may include a plurality of first scan stages SST11 to SST1n which sequentially outputs the first scan signal SCAN1 to the plurality of first scan lines S11 to S1n in the unit of pixel rows.

The second scan driver SDV2 may sequentially supply the second scan signal SCAN2 to the plurality of second scan lines S21 to S2n in response to the second scan start signal SVST2. For example, the second scan driver SDV2 may include a plurality of second scan stages SST21 to SST2n which sequentially outputs the second scan signal SCAN2 to the plurality of second scan lines S21 to S2n in the unit of pixel rows.

The third scan driver SDV3 may sequentially supply the third scan signal SCAN3 to the plurality of third scan lines S31 to S3n in response to the third scan start signal SVST3. For example, the third scan driver SDV3 may include a plurality of third scan stages SST31 to SST3n which sequentially outputs the third scan signal SCAN3 to the plurality of third scan lines S31 to S3n in the unit of pixel rows.

The fourth scan driver SDV4 may sequentially supply the fourth scan signal SCAN4 to the plurality of fourth scan lines S41 to S4n in response to the fourth scan start signal SVST4. For example, the fourth scan driver SDV4 may include a plurality of fourth scan stages SST41 to SST4n which sequentially outputs the fourth scan signal SCAN4 to the plurality of fourth scan lines S41 to S4n in the unit of pixel rows.

The emission driver EDV may sequentially supply the emission control signal EM to the plurality of emission control lines EL1 to ELn in response to the emission start signal EVST. For example, the emission driver EDV may include a plurality of emission stages EST1 to ESTn which sequentially outputs the emission control signal EM to the plurality of emission control lines EL1 to ELn in the unit of pixel rows.

In the meantime, as described above, the display device 100 according to the example embodiment of the present disclosure may display the images at various driving frequencies according to a driving condition. For example, the display device 100 may control the driving frequency of the display panel 140 by adjusting the number of times of second display periods DP2 which has been described with reference to FIGS. 3 to 4B. For example, in the second display period DP2, the third scan driver SDV3 sequentially supplies the third scan signal SCAN3 to the plurality of third scan lines S31 to S3n and the emission driver EDV may sequentially supply the emission control signal EM to the plurality of emission control lines EL1 to ELn. In the meantime, in the second display period DP2, the first scan driver SDV1, the second scan driver SDV2, and the fourth scan driver SDV4 may not supply the first scan signal SCAN1, the second scan signal SCAN2, and the fourth scan signal SCAN4, respectively. That is, in the second display period DP2, the first scan signal SCAN1, the second scan signal SCAN2, and the fourth scan signal SCAN4 may be maintained at a gate-off level, respectively.

Further, as described with reference to FIGS. 1 to 2B, in one example embodiment, in the display device 100, the plurality of sub active areas included in the active area AA may be independently driven at driving frequencies. For example, in the display panel 140 of FIG. 2B, the first sub active area AA1 and the third sub active area AA3 are driven at a low frequency and the second sub active area AA2 is driven at a high frequency. At this time, in one frame period, the number of times of driving a pixel PX disposed in the first sub active area AA1 and a pixel PX disposed in the third sub active area AA3 in the second display period DP2 may be larger than the number of times of driving a pixel PX disposed in the second sub active area AA2 in the second display period DP2. That is, when in the display panel 140 of FIG. 2B, the first sub active area AA1 and the third sub active area AA3 are driven at a low frequency and the second sub active area AA2 is driven at a high frequency, the display device 100 drives the pixel PX at a low frequency by increasing the number of times of driving the pixel PX in the second display period DP2 in the first sub active area AA1 and the third sub active area AA3.

In the meantime, the general gate driver of the related art is implemented as a shift register so that a current stage outputs the gate signal in response to a carry signal output from a previous stage. Further, in order to control the driving frequency of the pixel disposed in the display panel, the display device of the related art outputs a start signal for generating the corresponding scan signal at a gate-off level to supply the start signal to the gate driver or may control the carry signal of the gate driver to be output at a gate-off level to maintain signal levels of the first scan signal SCAN1, the second scan signal SCAN2, and the fourth scan signal SCAN4 to the gate-off level in the above-described second display period DP2.

However, as described above, when in the display panel 140, the first sub active area AA1 and the third sub active area AA3 are driven at a low frequency and the second sub active area AA2 is driven at a high frequency, in the gate driver of the related art which is implemented as a general shift register, a carry signal output from the stage which supplies the gate signal (scan signal) to the pixel disposed in the first sub active area AA1 is output at a gate-off level. Therefore, the gate signal (scan signal) which is supplied to the pixel disposed in the second sub active area AA2 should be maintained at a gate-off level. Accordingly, a gate driver of the related art and a display device including the same have limitations in dividing the active area into areas to control the driving frequency.

Accordingly, in the case of the gate driver 120 according to the example embodiment of the present disclosure, one stage may include a carry circuit which outputs a carry signal and an output circuit which controls whether to control a gate signal (scan signal). Accordingly, the gate driver 120 according to the example embodiment of the present disclosure and the display device 100 including the same divide the active area AA into areas to control the driving frequency.

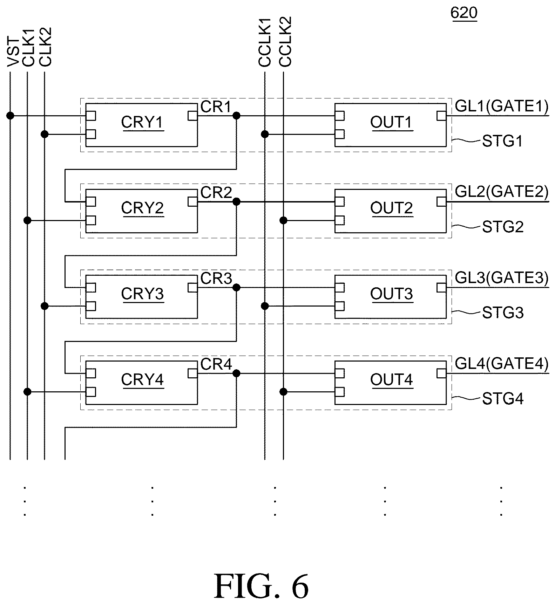

A specific description thereof will be made below with reference to FIGS. 6 to 17.

FIG. 6 is a block diagram illustrating an example of a gate driver of FIG. 5.

For example, a plurality of stages STG1 to STG4 included in a gate driver 620 illustrated in FIG. 6 may correspond to a plurality of scan stages included in any one of a first scan driver SDV1, a second scan driver SDV2, and a fourth scan driver SDV4 included in the gate driver 120 which has been described with reference to FIG. 5. That is, at least any one of the first scan driver SDV1, the second scan driver SDV2, and the fourth scan driver SDV4 is implemented as the gate driver 620 illustrated in FIG. 6 to control an output frequency of a scan signal of the corresponding scan driver. For example, a start signal VST illustrated in FIG. 6 may correspond to any one of a first scan start signal SVST1 supplied to the first scan driver SDV1, a second scan start signal SVST2 supplied to the second scan driver SDV2, and a fourth scan start signal SVST4 supplied to the fourth scan driver SDV4 which have been described with reference to FIG. 5. However, this is just illustrative so that the example embodiment of the present disclosure is not limited thereto.

In the meantime, for the convenience of description, in FIG. 6, four stages STG1 to STG4 included in the gate driver 620 and a plurality of gate signals GATE1 to GATE4 output therefrom were illustrated.

Referring to FIG. 6, the gate driver 620 may include a plurality of stages STG1 to STG4. Each of the plurality of stages STG1 to STG4 is connected to a corresponding one of the gate lines GL1 to GL4 and may output a corresponding one of the gate signals GATE1 to GATE4 based on one or more of a plurality of clock signals CLK1 and CLK2 and a plurality of control clock signals CCLK1 and CCLK2.

In one example embodiment, the plurality of stages STG1 to STG4 included in the gate driver 620 may be cascaded.

For example, the second stage STG2 is cascaded to the first stage STG1, the third stage STG3 is cascaded to the second stage STG2, and the fourth stage STG4 may be cascaded to the third stage STG3. Here, the plurality of stages STG1 to STG4 may have the substantially same configuration.

Each of the plurality of stages STG1 to STG4 may include a carry circuit which outputs a carry signal and an output circuit which controls whether to output a gate signal. For example, a first stage STG1 includes a first carry circuit CRY1 which generates a first carry signal CR1 and a first output circuit OUT1 which controls whether to output a first gate signal GATE1. A second stage STG2 includes a second carry circuit CRY2 which generates a second carry signal CR2 and a second output circuit OUT2 which controls whether to output a second gate signal GATE2. A third stage STG3 includes a third carry circuit CRY3 which generates a third carry signal CR3 and a third output circuit OUT3 which controls whether to output a third gate signal GATE3. A fourth stage STG4 may include a fourth carry circuit CRY4 which generates a fourth carry signal CR4 and a fourth output circuit OUT4 which controls whether to output a fourth gate signal GATE4.

Each of the plurality of carry circuits CRY1 to CRY4 included in the plurality of stages STG1 to STG4 may receive an input signal. For example, the first carry circuit CRY1 may receive a start signal VST. Further, each of the second to fourth carry circuits CRY2 to CRY4 may receive a carry signal output from a carry circuit in a previous stage, for example, any one of the first to third carry signals CR1 to CR3. For example, the second carry circuit CRY2 receives the first carry signal CR1 output from the first carry circuit CRY1, the third carry circuit CRY3 receives the second carry signal CR2 output from the second carry circuit CRY2, and the fourth carry circuit CRY4 may receive the third carry signal CR3 output from the third carry circuit CRY3.

Further, each of the plurality of carry circuits CRY1 to CRY4 may be supplied with any one of the plurality of clock signals, for example, the first clock signal CLK1 and a second clock signal CLK2.

In one example embodiment, a carry circuit included in an even-numbered stage receives the first clock signal CLK1 and a carry circuit included in an odd-numbered stage may receive the second clock signal CLK2. For example, the first carry circuit CRY1 and the third carry circuit CRY3 receive the second clock signal CLK2, respectively and the second carry circuit CRY2 and the fourth carry circuit CRY4 may receive the first clock signal CLK1, respectively. However, this is illustrative and the carry circuit included in the odd-numbered stage receives the first clock signal CLK1 and the carry circuit included in the even-numbered stage may receive the second clock signal CLK2.

The first clock signal CLK1 and the second clock signal CLK2 have the same cycle and have waveforms in which phases do not overlap each other. For example, the second clock signal CLK2 may be set to a signal which is shifted by approximately a half cycle from the first clock signal CLK1.

The plurality of carry circuits CRY1 to CRY4 outputs carry signals CR1 to CR4 through output terminals to be supplied to a carry circuit of a subsequent stage. For example, the first carry signal CR1 output from the first carry circuit CRY1 is supplied to the second carry circuit CRY2, the second carry signal CR2 output from the second carry circuit CRY2 is supplied to the third carry circuit CRY3, and the third carry signal CR3 output from the third carry circuit CRY3 may be supplied to the fourth carry circuit CRY4.

Further, the plurality of carry signals CR1 to CR4 output from the plurality of carry circuits CRY1 to CRY4 included in the plurality of stages STG1 to STG4 may be supplied to output circuits OUT1 to OUT4 of the corresponding stage.

For example, the first carry signal CR1 output from the first carry circuit CRY1 of the first stage STG1 is supplied to the first output circuit OUT1 and the second carry signal CR2 output from the second carry circuit CRY2 of the second stage STG2 is supplied to the second output circuit OUT2. The third carry signal CR3 output from the third carry circuit CRY3 of the third stage STG3 is supplied to the third output circuit OUT3 and the fourth carry signal CR4 output from the fourth carry circuit CRY4 of the fourth stage STG4 may be supplied to the fourth output circuit OUT4.

Further, each of the plurality of output circuits OUT1 to OUT4 may be supplied with any one of a plurality of control clock signals, for example, a first control clock signal CCLK1 and a second control clock signal CCLK2.

In one example embodiment, an output circuit included in an odd-numbered stage receives the first control clock signal CCLK1 and an output circuit included in an even-numbered stage may receive the second control clock signal CCLK2. For example, the first output circuit OUT1 and the third output circuit OUT3 receive the first control clock signal CCLK1, respectively and the second output circuit OUT2 and the fourth output circuit OUT4 may receive the second control clock signal CCLK2, respectively. However, this is illustrative and the output circuit included in the even-numbered stage receives the first control clock signal CCLK1 and the output circuit included in the odd-numbered stage may receive the second control clock signal CCLK2.

The first control clock signal CCLK1 and the second control clock signal CCLK2 have the same cycle and have waveforms in which phases do not overlap each other. For example, the second control clock signal CCLK2 may be set to a signal which is shifted by approximately a half cycle from the first control clock signal CCLK1.

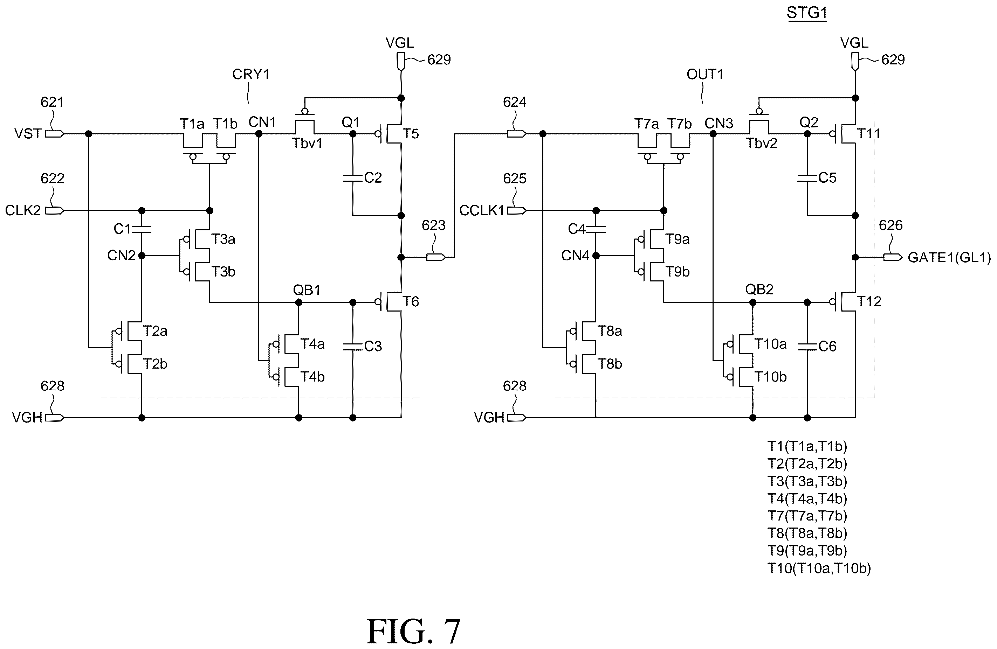

In one example embodiment, a signal level of at least any one of the first control clock signal CCLK1 and the second control clock signal CCLK2 may be controlled according to a driving mode. For example, the signal levels of the first control clock signal CCLK1 and the second control clock signal CCLK2 may be independently controlled. For example, as described above, in order to drive the pixel PX in the second display period DP2, at least one of the first control clock signal CCLK1 and the second control clock signal CCLK2 is maintained at a gate-off level, for example, a high level during a corresponding period. Therefore, the output circuit to which the corresponding control clock signal is applied may supply a gate-off level of gate signal. Detailed description thereof will be made below with reference to FIGS. 7 to 9C.

A plurality of output circuits OUT1 to OUT4 included in the plurality of stages STG1 to STG4 may output gate signals GATE1 to GATE4, respectively. In one example embodiment, a plurality of gate signals GATE1 to GATE4 output from the plurality of corresponding output circuits OUT1 to OUT4 may be supplied to corresponding gate lines GL1 to GL4, respectively.

In the meantime, even though it is not separately illustrated in FIG. 6, each of the plurality of stages STG1 to STG4 includes a plurality of power input terminals, and a power voltage required to drive the plurality of stages STG1 to STG4 may be applied through the plurality of power input terminals.

For example, each of the plurality of stages STG1 to STG4 may receive a voltage of a first power source (for example, a first power source VGH of FIG. 7) and a voltage of a second power source (for example, a second power source VGL of FIG. 7). The voltage of the first power source and the voltage of the second power source may have a DC voltage level. Here, a voltage level of the first power source may be set to be higher than a voltage level of the second power source.

In one example embodiment, the plurality of stages STG1 to STG4 included in the gate driver 620 may have the substantially same configuration, excluding a type of an input signal. For example, the first stage STG1 which is an initial stage which receives the start signal VST and the remaining stages which receive carry signals of a previous stage, for example, second to fourth stages STG2 to STG4 have the substantially same circuit configuration and operate in the substantially same manner except for an input signal, that is, the start signal VST or the carry signal of the previous stage.

Accordingly, hereinafter, for the convenience of description, when the plurality of stages STG1 to STG4 included in the gate driver 620 is described below, a configuration and a driving method of the plurality of stages STG1 to STG4 included in the gate driver 620 will be described with respect to the first stage STG1.

In the meantime, transistors which configure each stage may be implemented by n-type or p-type metal-oxide-semiconductor field-effect transistors (MOSFETs). In the following example embodiment, even though a p-type transistor is illustrated, but the example embodiment of the present disclosure is not limited thereto. For example, n-type transistors, or a combination of n-type and p-type transistors may be utilized. In another example, other types of transistors may be utilized.

FIG. 7 is a circuit diagram illustrating an example of a first stage included in a gate driver of FIG. 6.

Referring to FIGS. 6 and 7, the first stage STG1 may include a first carry circuit CRY1 which outputs a first carry signal CR1 and a first output circuit OUT1 which outputs a first gate signal GATE1. To be more specific, the first output circuit OUT1 may output a first gate signal GATE1 having a gate-on level of pulse or a first gate signal GATE1 which is maintained at a gate-off level, according to a driving mode.

The first carry circuit CRY1 receives an input signal, for example, a start signal VST, through a first input terminal 621, receives a second clock signal CLK2 through a second input terminal 622, and is connected to the first power source VGH through a first power input terminal 628 and may be connected to the second power source VGL through a second power input terminal 629. The first carry circuit CRY1 may generate and output the first carry signal CR1 through the first output terminal 623, based on the start signal VST, the second clock signal CLK2, the first power source VGH, and the second power source VGL.

The first output circuit OUT1 receives the first carry signal CR1 through a third input terminal, for example, the third input terminal 624 connected to the first output terminal 623 of the first carry circuit CRY1 and receives the first control clock signal CCLK1 through a fourth input terminal 625. The first output circuit OUT1 is connected to the first power source VGH through the first power input terminal 628 and may be connected to the second power source VGL through the second power input terminal 629. The first output circuit OUT1 may generate and output the first gate signal GATE1 through the second output terminal 626, for example, the first gate line GL1, based on the first carry signal CR1, the first control clock signal CCLK1, the first power source VGH, and the second power source VGL.

To be more specific, the first carry circuit CRY1 of the first stage STG1 may include first to sixth transistors T1 to T6, a first capacitor C1, a second capacitor C2, and a third capacitor C3. According to the example embodiment, the first carry circuit CRY1 further may include a first bridge voltage transistor Tbv1.

The first transistor T1 is connected between the first input terminal 621 and a first control node CN1 and may include a gate electrode connected to a second input terminal 622. The first transistor T1 is turned on when a second clock signal CLK2 supplied through the second input terminal 622 has a gate-on level, for example, a low level, to electrically connect the first input terminal 621 and the first control node CN1. When the first transistor T1 is turned on, the start signal VST supplied through the first input terminal 621 may be supplied to the first control node CN1.

In one example embodiment, the first transistor T1 may include first and second sub transistors T1a and T1b which are connected in series. Each of the first and second sub transistors T1a and T1b may include a gate electrode which is commonly connected to the second input terminal 622. For example, the first transistor T1 may have a dual gate structure. Accordingly, the current leakage by the first transistor T1 may be minimized.

The second transistor T2 is connected between the first power input terminal 628 and the second control node CN2 and may include a gate electrode connected to the first input terminal 621. The second transistor T2 is turned on when the start signal VST supplied through the first input terminal 621 has a gate-on level, for example, a low level, to supply a gate-off level, for example, a high level of voltage of the first power source VGH supplied from the first power input terminal 628 to the second control node CN2.

In one example embodiment, the second transistor T2 may include third and fourth sub transistors T2a and T2b which are connected in series. Each of the third and fourth sub transistors T2a and T2b may include a gate electrode which is commonly connected to the first input terminal 621. For example, the second transistor T2 may have a dual gate structure. Accordingly, the current leakage by the second transistor T2 may be minimized.

The third transistor T3 is connected between the second input terminal 622 and a first QB node QB1 and may include a gate electrode connected to the second control node CN2. The third transistor T3 may be turned on or turned off based on a voltage of the second control node CN2. If the third transistor T3 is turned on, the second input terminal 622 and the first QB node QB1 are electrically connected to supply the second clock signal CLK2 which is supplied to the second input terminal 622 to the first QB node QB1.

In one example embodiment, the third transistor T3 may include fifth and sixth sub transistors T3a and T3b which are connected in series. Each of the fifth and sixth sub transistors T3a and T3b may include a gate electrode which is commonly connected to the second control node CN2. For example, the third transistor T3 may have a dual gate structure. Accordingly, the current leakage by the third transistor T3 may be minimized.

The fourth transistor T4 is connected between the first power input terminal 628 and the first QB node QB1 and may include a gate electrode connected to the first control node CN1. The fourth transistor T4 may be turned on or turned off based on a voltage of the first control node CN1. If the fourth transistor T4 is turned on, a voltage of the first power source VGH supplied through the first power input terminal 628 may be supplied to the first QB node QB1.

In one example embodiment, the fourth transistor T4 may include seventh and eighth sub transistors T4a and T4b which are connected in series. Each of the seventh and eighth sub transistors T4a and T4b may include a gate electrode which is commonly connected to the first control node CN1. For example, the fourth transistor T4 may have a dual gate structure. Accordingly, the current leakage by the fourth transistor T4 may be minimized.

The fifth transistor T5 is connected between the second power input terminal 629 and the first output terminal 623 and may include a gate electrode connected to a first Q node Q1. For example, a gate electrode of the fifth transistor T5 which is connected to the first Q node Q1 may be connected to the first control node CN1 via a first bridge voltage transistor Tbv1. The fifth transistor T5 may be turned on or turned off by the voltage of the first Q node Q1.

Here, the first bridge voltage transistor Tbv1 is connected between the first control node CN1 and the first Q node Q1 and may include a gate electrode connected to the second power input terminal 629. A gate electrode of the first bridge voltage transistor Tbv1 is connected to the second power input terminal 629 to which a gate-on level, for example, a low level of a voltage of the second power source VGL is supplied so that the first bridge voltage transistor Tbv1 may maintain a turned-on state at all times. Accordingly, the voltage of the first control node CN1 and the voltage of the first Q node Q1 may have the substantially same value. Therefore, the fifth transistor T5 may be turned on or turned off according to the voltage of the first control node CN1.

For example, when the voltage of the first Q node Q1 or the voltage of the first control node CN1 may have a gate-on level, for example, a low level, the fifth transistor T5 is turned on to electrically connect the second power input terminal 629 and the first output terminal 623. Accordingly, in the period in which the fifth transistor T5 is turned on, the first carry signal CR1 output through the first output terminal 623 may have a gate-on level, for example, a low level.

The sixth transistor T6 is connected between the first power input terminal 628 and the first output terminal 623 and may include a gate electrode connected to the first QB node QB1. The sixth transistor T6 may be turned on or turned off by a voltage of the first QB node QB1.

For example, when the voltage of the first QB node QB1 may have a gate-on level, for example, a low level, the sixth transistor T6 is turned on to electrically connect the first power input terminal 628 and the first output terminal 623. Accordingly, in the period in which the sixth transistor T6 is turned on, the first carry signal CR1 output through the first output terminal 623 may have a gate-off level, for example, a high level.

As described above, the fifth transistor T5 of the first carry circuit CRY1 performs a pull-up function and the sixth transistor T6 of the first carry circuit CRY1 may perform a pull-down function.

The first capacitor C1 (or a first boosting capacitor) may be connected between the second input terminal 622 and the second control node CN2. For example, the first capacitor C1 may include a first electrode connected to the second input terminal 622 and a second electrode connected to the second control node CN2.

The second capacitor C2 may be connected between the first Q node Q1 and the first output terminal 623. For example, the second capacitor C2 may include a first electrode connected to the first Q node Q1 and a second electrode connected to the first output terminal 623.

The third capacitor C3 may be connected between the first QB node QB 1 and the first output terminal 623. For example, the third capacitor C3 may include a first electrode connected to the first QB node QB1 and a second electrode connected to the first output terminal 623.

Next, the first output circuit OUT1 of the first stage STG1 may have the similar circuit structure as the first carry circuit CRY1 except for a signal to be input and a signal to be output. For example, the first output circuit OUT1 may include seventh to twelfth transistors T7 to T12, a fourth capacitor C4, a fifth capacitor C5, and a sixth capacitor C6. According to the example embodiment, the first output circuit OUT1 may further include a second bridge voltage transistor Tbv2.

The seventh transistor T7 is connected between the third input terminal 624 and a third control node CN3 and may include a gate electrode connected to the fourth input terminal 625. The seventh transistor T7 is turned on when a first control clock signal CCLK1 supplied through the fourth input terminal 625 has a gate-on level, for example, a low level, to electrically connect the third input terminal 624 and the third control node CN3. When the seventh transistor T7 is turned on, the first carry signal CR1 supplied through the third input terminal 624 may be supplied to a third control node CN3.

In one example embodiment, the seventh transistor T7 may include ninth and tenth sub transistors T7a and T7b which are connected in series. Each of the ninth and tenth sub transistors T7a and T7b may include a gate electrode which is commonly connected to the fourth input terminal 625. For example, the seventh transistor T7 may have a dual gate structure. Accordingly, the current leakage by the seventh transistor T7 may be minimized.

The eighth transistor T8 is connected between the first power input terminal 628 and a fourth control node CN4 and may include a gate electrode connected to the third input terminal 624. The eighth transistor T8 is turned on when the first carry signal CR1 supplied through the third input terminal 624 may have a gate-on level, for example, a low level, to supply a gate-off level, for example, a high level of voltage of the first power source VGH supplied from the first power input terminal 628 to the fourth control node CN4.

In one example embodiment, the eighth transistor T8 may include eleventh and twelfth sub transistors T8a and T8b which are connected in series. Each of the eleventh and twelfth sub transistors T8a and T8b may include a gate electrode which is commonly connected to the third input terminal 624. For example, the eighth transistor T8 may have a dual gate structure. Accordingly, the current leakage by the eighth transistor T8 may be minimized.

The ninth transistor T9 is connected between the fourth input terminal 625 and a second QB node QB2 and may include a gate electrode connected to the fourth control node CN4. The ninth transistor T9 may be turned on or turned off based on a voltage of the fourth control node CN4. If the ninth transistor T9 is turned on, the fourth input terminal 625 and the second QB node QB2 are electrically connected to supply a first control clock signal CCLK1 which is supplied to the fourth input terminal 625 to the second QB node QB2.

In one example embodiment, the ninth transistor T9 may include thirteenth and fourteenth sub transistors T9a and T9b which are connected in series. Each of the thirteenth and fourteenth sub transistors T9a and T9b may include a gate electrode which is commonly connected to the fourth control node CN4. For example, the ninth transistor T9 may have a dual gate structure. Accordingly, the current leakage by the ninth transistor T9 may be minimized.

The tenth transistor T10 is connected between the first power input terminal 628 and the second QB node QB2 and may include a gate electrode connected to the third control node CN3. The tenth transistor T10 may be turned on or turned off based on a voltage of the third control node CN3. If the tenth transistor T10 is turned on, a voltage of the first power source VGH supplied through the first power input terminal 628 may be supplied to the second QB node QB2.

In one example embodiment, the tenth transistor T10 may include fifteenth and sixteenth sub transistors T10a and T10b which are connected in series. Each of the fifteenth and sixteenth sub transistors T10a and T10b may include a gate electrode which is commonly connected to the third control node CN3. For example, the tenth transistor T10 may have a dual gate structure. Accordingly, the current leakage by the tenth transistor T10 may be minimized.

The eleventh transistor T11 is connected between the second power input terminal 629 and the second output terminal 626 and may include a gate electrode connected to a second Q node Q2. For example, a gate electrode of the eleventh transistor T11 which is connected to the second Q node Q2 is connected to the third control node CN3 via a second bridge voltage transistor Tbv2. The eleventh transistor T11 may be turned on or turned off by the voltage of the second Q node Q2.

Here, the second bridge voltage transistor Tbv2 includes a gate electrode connected to the second power input terminal 629, like the first bridge voltage transistor Tbv1, so that the second bridge voltage transistor Tbv2 may maintain a turned-on state at all times. Accordingly, the voltage of the third control node CN3 and the voltage of the second Q node Q2 have the substantially same value. Therefore, the eleventh transistor T11 may be turned on or turned off according to the voltage of the third control node CN3.

For example, when the voltage of the second Q node Q2 or the voltage of the third control node CN3 has a gate-on level, for example, a low level, the eleventh transistor T11 is turned on to electrically connect the second power input terminal 629 and the second output terminal 626. Accordingly, in the period in which the eleventh transistor T11 is turned on, the first gate signal GATE1 output through the second output terminal 626 may have a gate-on level, for example, a low level.

The twelfth transistor T12 is connected between the first power input terminal 628 and the second output terminal 626 and may include a gate electrode connected to the second QB node QB2. The twelfth transistor T12 may be turned on or turned off by a voltage of the second QB node QB2.

For example, when the voltage of the second QB node QB2 has a gate-on level, for example, a low level, the twelfth transistor T12 is turned on to electrically connect the first power input terminal 628 and the second output terminal 626. Accordingly, in the period in which the twelfth transistor T12 is turned on, the first gate signal GATE1 output through the second output terminal 626 may have a gate-off level, for example, a high level.

As described above, the eleventh transistor T11 of the first output circuit OUT1 performs a pull-up function and the twelfth transistor T12 of the first output circuit OUT1 may perform a pull-down function.

A fourth capacitor C4 (or a second boosting capacitor) may be connected between the fourth input terminal 625 and the fourth control node CN4. For example, the fourth capacitor C4 may include a first electrode connected to the fourth input terminal 625 and a second electrode connected to the fourth control node CN4.

The fifth capacitor C5 may be connected between the second Q node Q2 and the second output terminal 626. For example, the fifth capacitor C5 may include a first electrode connected to the second Q node Q2 and a second electrode connected to the second output terminal 626.

A sixth capacitor C6 may be connected between the second QB node QB2 and the second output terminal 626. For example, the sixth capacitor C6 may include a first electrode connected to the second QB node QB2 and a second electrode connected to the second output terminal 626.

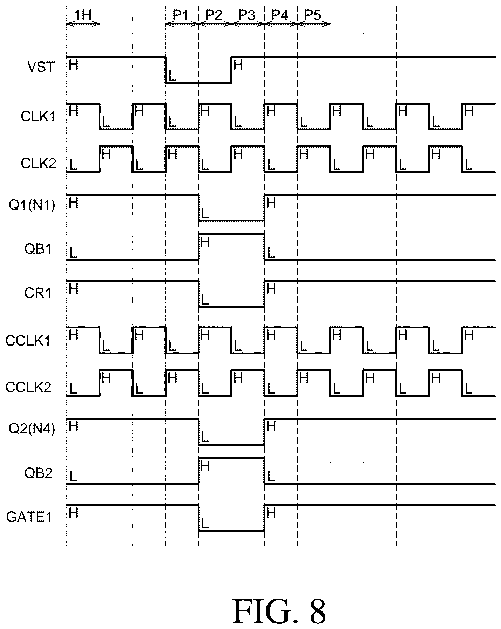

FIG. 8 is a waveform chart for explaining an example of an operation of a first stage of FIG. 7.

In the meantime, as described with reference to FIG. 8, the gate electrode of the first bridge voltage transistor Tbv1 and the gate electrode of the second bridge voltage transistor Tbv2 are connected to the second power input terminal 629 to which a voltage of the second power source VGL is supplied. Therefore, the first bridge voltage transistor Tbv1 and the second bridge voltage transistor Tbv2 may maintain a turned-on state during all the periods in which the gate driver 620 is driven, for example, first to fifth periods S1 to S5 and all the periods before and after the periods. Accordingly, the voltage of the first control node CN1 and the voltage of the first Q node Q1 have the substantially same value in all the periods and a voltage of the third control node CN3 and a voltage of the second Q node Q2 have the substantially same value in all the periods.

Referring to FIGS. 7 and 8, the first clock signal CLK1 and the second clock signal CLK2 may be supplied at different timings. For example, the second clock signal CLK2 may be set to a signal which is shifted by approximately a half cycle, for example, one horizontal period (1H) from the first clock signal CLK1.

Further, the first control clock signal CCLK1 and the second control clock signal CCLK2 may be supplied at different timings. For example, the second control clock signal CCLK2 may be set to a signal which is shifted by approximately a half cycle, for example, one horizontal period (1H) from the first control clock signal CCLK1.

In the meantime, the high voltage level, for example, a high level H, illustrated in FIG. 8 corresponds to a voltage of the first power source VGH and the low voltage level, for example, a low level L may correspond to a voltage of the second power source VGL. For example, the voltage of the first power source VGH is a positive voltage and the voltage of the second power source VGL may be a negative voltage. However, this is an example so that the high level H and the low level L are not limited thereto. For example, the high level H of voltage and the low level L of voltage may be set according to a type of a transistor and a usage environment of the display device.

Hereinafter, referring to FIGS. 6 to 8, an operation of a gate driver 620 according to an example embodiment of the present disclosure, for example, a first stage STG1, will be described and for the convenience of description, the operation of the first carry circuit CRY1 will be described first, and then an operation of the first output circuit OUT1 will be described.

First, an operation of the first carry circuit CRY1 will be described. During a period before the first period P1, the first Q node Q1 is maintained at a high level H and the first QB node QB1 may be maintained at a low level L. Accordingly, the fifth transistor T5 is maintained in a turned-off state and the sixth transistor T6 is maintained in a turned-on state so that the first carry signal CR1 may be output at a high level H.

During the first period P1 and the second period P2, the start signal VST supplied through the first input terminal 621 may have a low level L. Accordingly, during the first period P1 and the second period P2, the second transistor T2 may be turned on or may maintain a turned-on state.

Accordingly, in the first period P1 and the second period P2, a voltage of the first power source VGH supplied from the first power input terminal 628 through the turned-on second transistor T2 is supplied to the second control node CN2 so that the second control node CN2 may have a high level H. Further, during the first period P1 and the second period P2, the third transistor T3 is turned off or may have a turned-off state by the high level H of second control node CN2.

Further, during the first period P1, the second clock signal CLK2 supplied through the second input terminal 622 may have a high level H. Therefore, the first transistor T1 is turned off or may maintain a turn-off state in the first period P1.

As described above, in the first period P1, the first transistor T1 and the third transistor T3 are turned off or maintain a turned-off state so that in the first period P1, the first Q node Q1 and the first QB node QB1 may be maintained at a voltage level of a previous period of the first period P1. For example, in the first period P1, the first Q node Q1 has a high level H and the first QB node QB1 may have a low level L.

Next, during a second period P2, the second clock signal CLK2 supplied through the second input terminal 622 has a low level L so that the first transistor T1 may be turned on in the second period P2. Accordingly, the low level L of start signal VST is supplied to the first control node CN1 through the turned-on first transistor T1 so that the first control node CN1 and the first Q node Q1 may be shifted from the existing high level H to the low level L.

Further, during the second period P2, the first control node CN1 has a low level L so that the fourth transistor T4 is turned on and the first QB node QB1 may be shifted from the existing low level L to the high level H. Accordingly, the fifth transistor T5 is turned on and the sixth transistor T6 is turned off so that the first carry signal CR1 may be output at a low level L.

Next, in the third period P3, the start signal VST and the second clock signal CLK2 may be shifted to a high level H, respectively. Therefore, the first transistor T1 and the second transistor T2 are turned off or may maintain a turn-off state, respectively.

Further, in the third period P3, a voltage of the second control node CN2 may have a voltage level of the voltage of the first power source VGH supplied through the second transistor T2 which is turned on in the previous second period P2, that is, a high level H. Accordingly, the third transistor T3 is turned off or may maintain a turn-off state in the third period P3.

As described above, in the third period P3, the first transistor T1 and the third transistor T3 are turned off or maintain a turned-off state so that in the third period P3, the first Q node Q1 and the first QB node QB1 may be maintained at a voltage level of a second period P2 before the third period P3. For example, in the third period P3, the first Q node Q1 has a low level L and the first QB node QB1 may have a high level H. Accordingly, the fifth transistor T5 is turned on and the sixth transistor T6 is turned off so that the first carry signal CR1 may be output at a low level L.

Next, in the fourth period P4, a high level H of start signal VST and a low level L of second clock signal CLK2 may be supplied. Here, the second transistor T2 is maintained in a turned-off state by the high level H of start signal VST and the second clock signal CLK2 is shifted from the existing high level H to the low level L so that the voltage of the second control node CN2 may be shifted from the existing high level H to the low level L by the coupling of the first capacitor C1. Accordingly, in the fourth period P4, the first transistor T1 and the third transistor T3 are turned on to supply a high level H of start signal VST to the first control node CN1 so that the first Q node Q1 has a high level H. Further, the low level L of second clock signal CLK2 is supplied to the first QB node QB1 so that the first QB node QB1 may have a low level L. Accordingly, the fifth transistor T5 is turned off and the sixth transistor T6 is turned on so that the first carry signal CR1 may be output at a high level H.

Thereafter, during a period after the fifth period P5, including the fifth period P5, even though the second clock signal CLK2 is toggled to the low level L and the high level H, the start signal VST is maintained at a high level during the corresponding period. Therefore, the first Q node Q1 is maintained at a high level H and the first QB node QB1 may be maintained at a low level L.

Next, an operation of the first output circuit OUT1 will be described. During a period before the second period P2, including the first period P1, the second Q node Q2 is maintained at a high level H and the second QB node QB2 may be maintained at a low level L. Accordingly, the eleventh transistor T11 is maintained in a turned-off state and the twelfth transistor T12 is maintained in a turned-on state so that the first gate signal GATE1 may be output at a high level H.

As described above, the first carry signal CR1 may be output at a low level L in the second period P2 and the third period P3. Accordingly, during the second period P2 and the third period P3, the eighth transistor T8 may be turned on or may maintain a turned-on state.

Accordingly, in the second period P2 and the third period P3, a voltage of the first power source VGH supplied from the first power input terminal 628 through the turned-on eighth transistor T8 is supplied to the fourth control node CN4 so that the fourth control node CN4 may have a high level H. Further, during the second period P2 and the third period P3, the ninth transistor T9 is turned off or may have a turned-off state by the high level H of fourth control node CN4.

Further, during the second period P2, the first control clock signal CCLK1 supplied through the fourth input terminal 625 may have a high level H. Therefore, the seventh transistor T7 is turned off or may maintain a turned-off state in the second period P2.

As described above, in the second period P2, the seventh transistor T7 and the ninth transistor T9 are turned off or are maintained in a turned-off state so that in the second period P2, the second Q node Q2 and the second QB node QB2 may be maintained at a voltage level of a period before the second period P2, for example, the first period P1. For example, in the second period P2, the second Q node Q2 has a high level H and the second QB node QB2 may have a low level L.

Next, during a third period P3, the first control clock signal CCLK1 supplied through the fourth input terminal 625 has a low level L so that the seventh transistor T7 may be turned on in the third period P3. Accordingly, the low level L of first carry signal CR1 is supplied to the third control node CN3 through the turned-on seventh transistor T7 so that the third control node CN3 and the second Q node Q2 may be shifted from the existing high level H to the low level L.

Further, during the third period P3, the third control node CN3 has a low level L so that the tenth transistor T10 is turned on and the second QB node QB2 may be shifted from the existing low level L to the high level H. Accordingly, the eleventh transistor T11 is turned on and the twelfth transistor T12 is turned off so that the first gate signal GATE1 may be output at a low level L.

Next, in the fourth period P4, the first carry signal CR1 and the first control clock signal CCLK1 may be shifted to a high level H, respectively. Therefore, the seventh transistor T7 and the eighth transistor T8 are turned off or may be maintained in a turn-off state, respectively.

Further, in the fourth period P4, a voltage of the fourth control node CN4 may have a voltage level of the voltage of the first power source VGH supplied through the eighth transistor T8 which is turned on in the previous third period P3, that is, a high level H. Accordingly, the ninth transistor T9 is turned off or may be maintained in a turned-off state in the fourth period P4.

As described above, in the fourth period P4, the seventh transistor T7 and the ninth transistor T9 are turned off or may be maintained in a turned-off state so that in the fourth period P4, the second Q node Q2 and the second QB node QB2 may be maintained at a voltage level of a third period P3 before the fourth period P4. For example, in the fourth period P2, the second Q node Q2 has a low level L and the second QB node QB2 may have a high level H. Accordingly, the eleventh transistor T11 is turned on and the twelfth transistor T12 is turned off so that the first gate signal GATE1 may be output at a low level L.

Next, in the fifth period P5, a high level H of first carry signal CR1 and a low level L of first control clock signal CCLK1 may be supplied. Here, the eighth transistor T8 is maintained in a turned-off state by the high level H of first carry signal CR1 and the first control clock signal CCLK1 is shifted from the existing high level H to the low level L so that the voltage of the fourth control node CN4 may be shifted from the existing high level H to the low level L by the coupling of the fourth capacitor C4. Accordingly, in the fifth period P5, the seventh transistor T7 and the ninth transistor T9 are turned on to supply a high level H of first carry signal CR1 to the third control node CN3 so that the second Q node Q2 has a high level H. Further, the low level L of first control clock signal CCLK1 is supplied to the second QB node QB2 so that the second QB node QB2 may have a low level L. Accordingly, the eleventh transistor T11 is turned off and the twelfth transistor T12 is turned on so that the first gate signal GATE1 may be output at a high level H.

Thereafter, during a period after the fifth period P5, even though the first control clock signal CCLK1 is toggled to the low level L and the high level H, the first carry signal CR1 is maintained at a high level during the corresponding period. Therefore, the second Q node Q2 is maintained at a high level H and the second QB node QB2 may be maintained at a low level L.

As described above, in response to the first carry signal CR1 output by the first carry circuit CRY1, the first gate signal GATE1 output from the first output circuit OUT1 has the same pulse width as the first carry signal CR1 and may have a waveform shifted by one horizontal period (1H).

In the meantime, as described above, in the case of the gate driver 620 according to the example embodiment of the present disclosure and the display device 100 including the same, in order to control a driving frequency, an output circuit included in each stage is used to control a voltage level of a gate signal.

For example, unlike the waveform of FIG. 8, when the first control clock signal CCLK1 which is applied to the first output circuit OUT1 of the first stage STG1 is maintained at a gate-off level, for example, a high level H, the seventh transistor T7 may be maintained in a turned-off state. Accordingly, the low level L of first carry signal CR1 which is supplied to the third input terminal 624 is not supplied to the third control node CN3, so that the eleventh transistor T11 maintains a turned-off state during a period in which the first control clock signal CCLK1 is maintained at a high level H. Therefore, the first gate signal GATE1 which is output to the first gate line GL1 may be maintained at a gate-off level, for example, a high level H.

Accordingly, in the gate driver 620 according to the example embodiment of the present disclosure and the display device 100 including the same, output frequencies of a first scan driver SDV1, a second scan driver SDV2, and a fourth scan driver SDV4 included in the gate driver 620 may be adjusted by controlling a signal level of the first control clock signal CCLK1 or the second control clock signal CCLK2 applied to an output circuit of each stage. Accordingly, the gate driver 620 according to the example embodiment of the present disclosure and the display device 100 including the same may freely control a driving frequency in every area of the active area AA, for example, in the unit of pixel rows.

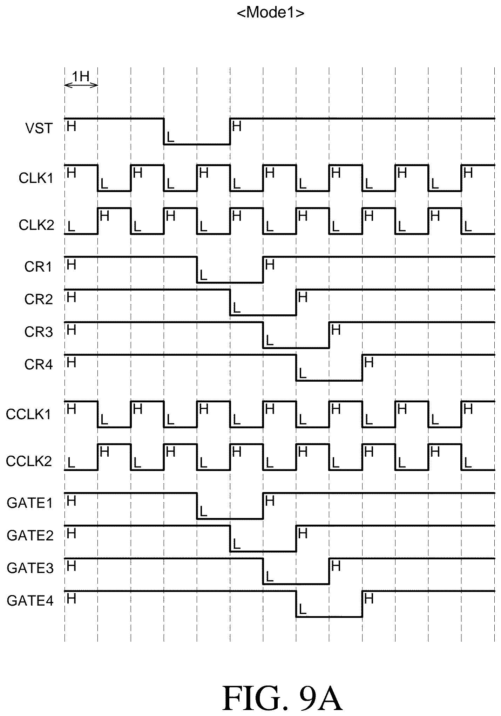

This will be described in more detail with reference to FIGS. 9A to 9C.

FIGS. 9A to 9C are waveform charts for explaining an example of an operation of a gate driver of FIG. 6.

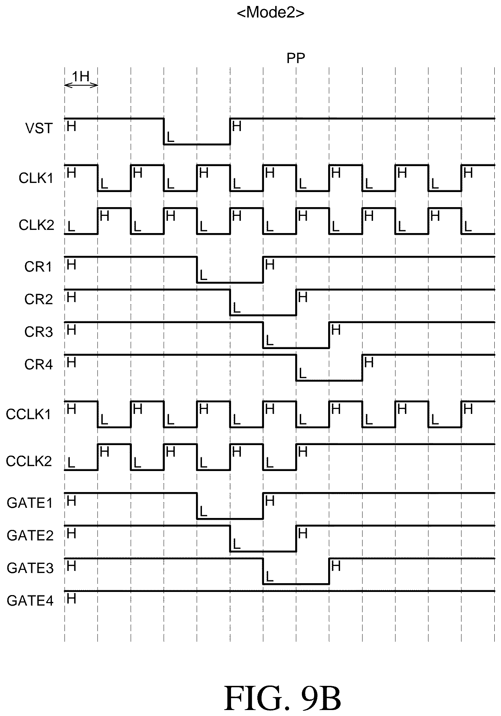

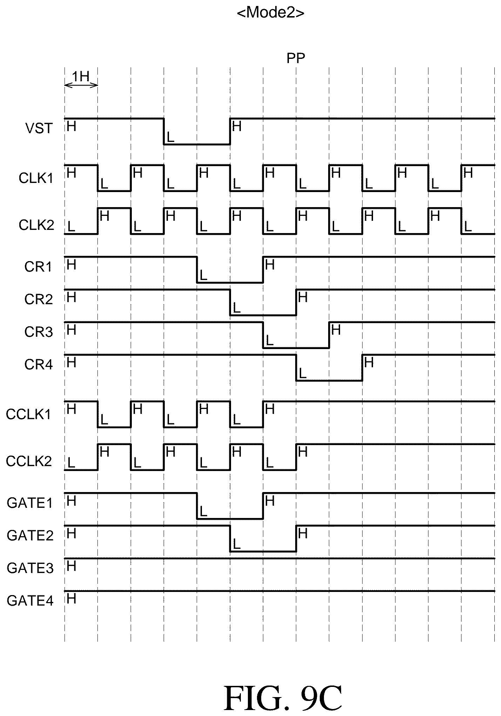

For example, in FIGS. 9A to 9C, in a first mode (denoted by "Model" in FIG. 9A) and a second mode (denoted by "Mode2" in each of FIGS. 9B and 9C), waveforms of a plurality of carry signals CR1 to CR4 output from the plurality of carry circuits CRY1 to CRY4 and a plurality of gate signals GATE1 to GATE4 output from the plurality of output circuits OUT1 to OUT4 together with the start signal VST, the first clock signal CLK1, the second clock signal CLK2, the first control clock signal CCLK1, and the second control clock signal CCLK2, among signals applied to the gate driver 620, are illustrated.

In the meantime, in one or more aspects of the present disclosure, the first mode may refer to a mode in which the plurality of gate signals GATE1 to GATE4 is sequentially output to all the pixel rows and in the first mode, pixels disposed in all the pixel rows are driven in the first display period DP1 which has been described with reference to FIG. 4A. The second mode may refer to a mode in which a gate signal output to the pixel PX disposed in at least one pixel row, among the plurality of pixel rows, is driven in a second display period DP2 which is maintained at a gate-off level.

First, when FIGS. 6, 7, and 9A are referenced to describe the first mode, the plurality of carry circuits CRY1 to CRY4 included in a plurality of stages STG1 to STG4 may sequentially output the plurality of carry signals CR1 to CR4, by the start signal VST, the first clock signal CLK1, and the second clock signal CLK2. For example, the plurality of carry signals CR1 to CR4 may be sequentially output in the unit of one horizontal period (1H).

In one example embodiment, in the first mode, the first control clock signal CCLK1 and the second control clock signal CCLK2 may be toggled between the high level H and the low level L. For example, in the first mode, each of the first control clock signal CCLK1 and the second control clock signal CCLK2 may be shifted from the high level H to the low level L or shifted from the low level L to the high level H at every half cycle.

Accordingly, in accordance with the driving of the stage which has been described with reference to FIGS. 7 and 8, each of the plurality of output circuits OUT1 to OUT4 included in the plurality of stages STG1 to STG4 may sequentially output a plurality of gate signals GATE1 to GATE4 having a gate-on level pulse, for example, a low level (L) pulse, based on the carry signals CR1 to CR4 supplied from the carry circuits CRY1 to CRY4 of the corresponding stage and the control clock signal.

Next, when FIGS. 6, 7, and 9B are referenced to describe the second mode, as the substantially same as the description which has been made with reference to FIG. 9A, the plurality of carry circuits CRY1 to CRY4 included in the plurality of stages STG1 to STG4 may sequentially output the plurality of carry signals CR1 to CR4, by the start signal VST, the first clock signal CLK1, and the second clock signal CLK2.

In the example embodiment, in the second mode, at least one of the first control clock signal CCLK1 and the second control clock signal CCLK2 may be maintained at a gate-off level, for example, a high level H in at least some period. For example, in the second mode, at least one of the first control clock signal CCLK1 and the second control clock signal CCLK2 may not be toggled in at least some period. In the meantime, as an example thereof, in FIG. 9B, it is illustrated that the second control clock signal CCLK2 is maintained at a high level H during a period after a transition time PP.

In this case, in the second mode, the first control clock signal CCLK1 is toggled during all the periods. Therefore, as an output circuit of a stage to which the first control clock signal CCLK1 is applied, a first output circuit OUT1 of an odd-numbered stage, for example, a first stage STG1 and a third output circuit OUT3 of a third stage STG3 may output a first gate signal GATE1 and a third gate signal GATE3 having a low level (L) pulse.

In contrast, in the second mode, the second control clock signal CCLK2 is maintained at a high level H after the transition time PP. Therefore, among gate signals output from a second output circuit OUT2 of an even-numbered stage, for example, a second stage STG2 and a fourth output circuit OUT4 of a fourth stage STG4, as an output circuit of a stage to which the second control clock signal CCLK2 is applied, a gate signal from which a low level (L) pulse needs to be output after the transition time PP, may be maintained at a gate-off level which is a high level H, without outputting the low level (L) pulse. For example, as illustrated in FIG. 9B, the second gate signal GATE2 output before the transition time PP has a low level (L) pulse and the fourth gate signal GATE4 may be maintained at a high level H by the second control clock signal CCLK2 which is maintained at a high level H after the transition time PP.

As another example, as illustrated in FIG. 9C, in the second mode, during all the periods after the transition time PP, when both the first control clock signal CCLK1 and the second control clock signal CCLK2 are maintained at a high level H, among the plurality of gate signals GATE1 to GATE4 output from output circuits OUT1 to OUT4 of the plurality of stages STG1 to STG4, a gate signal from which a low level (L) pulse needs to be output after the transition time PP may be maintained at a gate-off level which is a high level H without outputting the low level (L) pulse. For example, as illustrated in FIG. 9C, the first gate signal GATE1 and the second gate signal GATE2 which are output before the transition time PP have a low level (L) pulse and each of the third gate signal GATE3 and the fourth gate signal GATE4 may be maintained at a high level H by the first control clock signal CCLK1 and the second control clock signal CCLK2 which are maintained at a high level H after the transition time PP.

In the meantime, in FIGS. 9B and 9C, it is illustrated that in the second mode, the first control clock signal CCLK1 and/or the second control clock signal CCLK2 is maintained at a high level H during a period after the transition time PP, but the example embodiment of the present disclosure is not limited thereto.

For example, in the second mode, during the period before the transition time PP, the first control clock signal CCLK1 and/or the second control clock signal CCLK2 is maintained at a high level H and during a period after the transition time PP, the first control clock signal CCLK1 and the second control clock signal CCLK2 may be toggled between a high level H and a low level L.

As another example, in the second mode, in the period before the transition time PP, any one of the first control clock signal CCLK1 and the second control clock signal CCLK2 is maintained at the high level H. Further, during the period after the transition time PP, the other one of the first control clock signal CCLK1 and the second control clock signal CCLK2 may be maintained at the high level H.

Still in another example, in the entire period in which it is driven in the second mode, the first control clock signal CCLK1 and/or the second control clock signal CCLK2 may be maintained at a high level H.

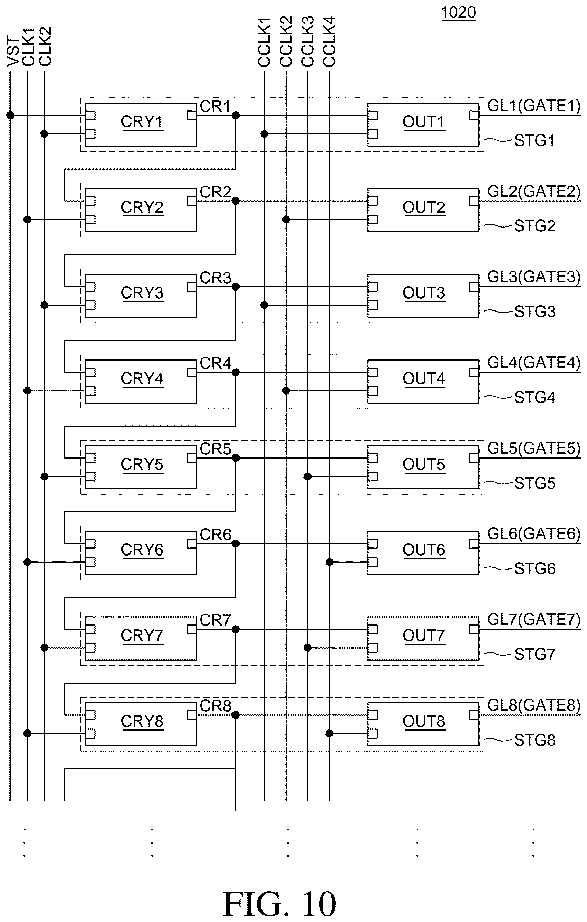

FIG. 10 is a block diagram illustrating another example of a gate driver of FIG. 5.

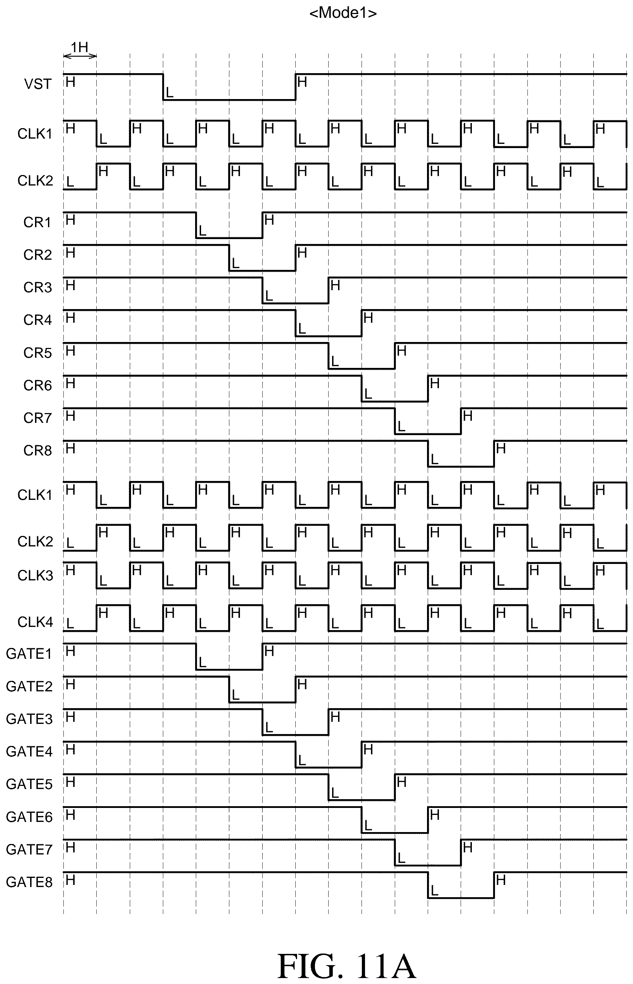

FIGS. 11A to 11C are waveform charts for explaining an example of an operation of a gate driver of FIG. 10.

In the meantime, a gate driver 1020 illustrated in FIG. 10 is a modified embodiment for the gate driver 620 which has been described with reference to FIG. 6, with regard to a plurality of control clock signals CCLK1, CCLK2, CCLK3, and CCLK4 and a connection relationship thereof. Accordingly, for the convenience of description, a redundant description will not be repeated.

In the meantime, for the convenience of description, in FIG. 10, eight stages STG1 to STG8 included in the gate driver 1020 and a plurality of gate signals GATE1 to GATE8 output therefrom were illustrated.

Referring to FIG. 10, the gate driver 1020 may include a plurality of stages STG1 to STG8. A plurality of stages STG1 to STG8 is connected to corresponding gate lines GL1 to GL8 to output gate signals GATE1 to GATE8.

Each of the plurality of stages STG1 to STG8 may include carry circuits CRY1 to CRY8 which output a carry signal and output circuits OUT1 to OUT8 which control whether to output a gate signal.

Each of the plurality of carry circuits CRY1 to CRY8 included in the plurality of stages STG1 to STG8 may output carry signals CR1 to CR8 based on an input signal, for example, a start signal VST or a carry signal which is supplied from a carry circuit of a previous stage and a plurality of clock signals CLK1 and CLK2.

Each of the plurality of output circuits OUT1 to OUT8 may be supplied with any one of a plurality of control clock signals, for example, a first control clock signal CCLK1, a second control clock signal CCLK2, a third control clock signal CCLK3, and a fourth control clock signal CCLK4.

In one example embodiment, output circuits included in a k-th (k is an integer larger than 0) stage and a k+2-th stage receive a first control clock signal CCLK1 and output circuits included in a k+1-th stage and a k+3-th stage receive a second control clock signal CCLK2. Output circuits included in a k+4-th stage and a k+6-th stage receive a third control clock signal CCLK3 and output circuits included in a k+5-th stage and a k+7-th stage may receive a fourth control clock signal CCLK4.

For example, the first output circuit OUT1 and the third output circuit OUT3 receive a first control clock signal CCLK1, respectively and the second output circuit OUT2 and the fourth output circuit OUT4 receive a second control clock signal CCLK2, respectively. The fifth output circuit OUT5 and the seventh output circuit OUT7 receive a third control clock signal CCLK3, respectively and the sixth output circuit OUT6 and the eighth output circuit OUT8 may receive a fourth control clock signal CCLK4, respectively.

The first control clock signal CCLK1 and the second control clock signal CCLK2 have the same cycle and have waveforms in which phases do not overlap each other. For example, the second control clock signal CCLK2 may be set to a signal which is shifted by approximately a half cycle from the first control clock signal CCLK1.

Further, the third control clock signal CCLK3 and the fourth control clock signal CCLK4 have the same cycle and have waveforms in which phases do not overlap each other. For example, the fourth control clock signal CCLK4 may be set to a signal which is shifted by approximately a half cycle from the third control clock signal CCLK3.

In the example embodiment, as described above, except that the gate driver 1020 is driven in a second mode so that any one of the first control clock signal CCLK1, the second control clock signal CCLK2, the third control clock signal CCLK3, and the fourth control clock signal CCLK4 is maintained at the high level H, the first control clock signal CCLK1 and the third control clock signal CCLK3 have the same waveform and the second control clock signal CCLK2 and the fourth control clock signal CCLK4 may have the same waveform.

In one example embodiment, a signal level of at least any one of the first control clock signal CCLK1, the second control clock signal CCLK2, the third control clock signal CCLK3, and the fourth control clock signal CCLK4 may be controlled according to a driving mode. For example, signal levels of the first control clock signal CCLK1, the second control clock signal CCLK2, the third control clock signal CCLK3, and the fourth control clock signal CCLK4 may be independently controlled. For example, as described above, in order to drive the pixel PX in the second display period DP2, at least one of the first control clock signal CCLK1, the second control clock signal CCLK2, the third control clock signal CCLK3, and the fourth control clock signal CCLK4 is maintained at a gate-off level, for example, a high level H during a corresponding period. Therefore, the output circuit to which the corresponding control clock signal is applied may supply a gate-off level, for example, a high level H of gate signal.

For example, further referring to FIG. 11A, in the first mode, the plurality of carry circuits CRY1 to CRY8 included in a plurality of stages STG1 to STG8 may sequentially output the plurality of carry signals CR1 to CR8, by the start signal VST, the first clock signal CLK1, and the second clock signal CLK2.

In one example embodiment, in the first mode, the first control clock signal CCLK1, the second control clock signal CCLK2, the third control clock signal CCLK3, and the fourth control clock signal CCLK4 may be toggled between the high level H and the low level L, respectively. For example, in the first mode, the first control clock signal CCLK1, the second control clock signal CCLK2, the third control clock signal CCLK3, and the fourth control clock signal CCLK4 may be shifted from the high level H to the low level L or shifted from the low level L to the high level H at every half cycle, respectively.

Accordingly, each of the plurality of output circuits OUT1 to OUT8 included in the plurality of stages STG1 to STG8 may sequentially output a plurality of gate signals GATE1 to GATE8 having a gate-on level pulse, for example, a low level (L) pulse, based on the carry signals CR1 to CR8 supplied from the carry circuits CRY1 to CRY8 of the corresponding stage and the control clock signal.

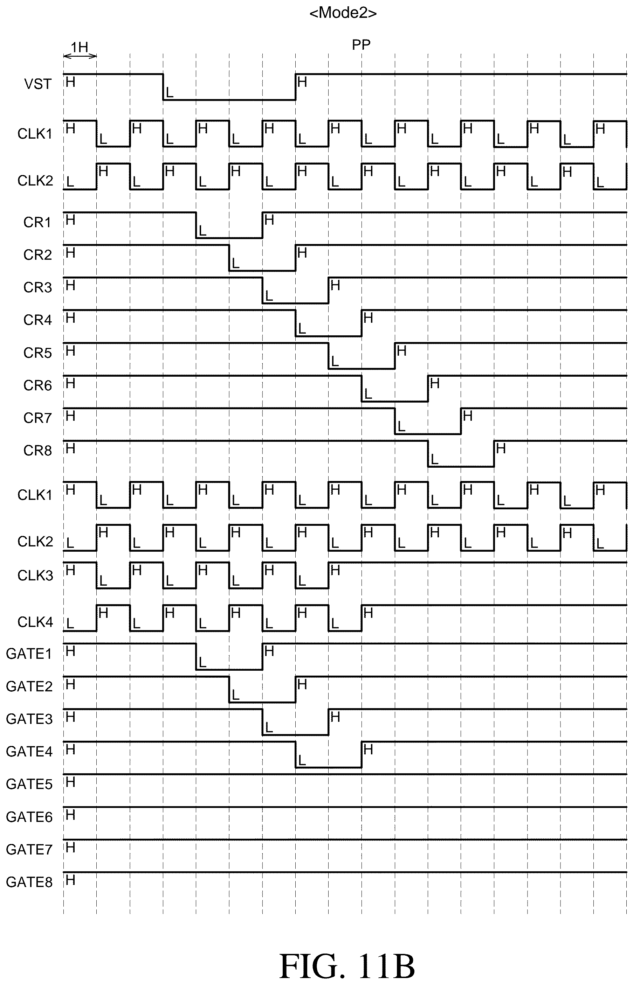

Next, when FIG. 11B is referenced to describe the second mode, as the substantially same as the description which has been made with reference to FIG. 11A, the plurality of carry circuits CRY1 to CRY8 included in the plurality of stages STG1 to STG8 may sequentially output the plurality of carry signals CR1 to CR8, by the start signal VST, the first clock signal CLK1, and the second clock signal CLK2.

In the example embodiment, in the second mode, at least one of the first control clock signal CCLK1, the second control clock signal CCLK2, the third control clock signal CCLK3, and the fourth control clock signal CCLK4 is maintained at a gate-off level, for example, a high level H in at least some period. For example, in the second mode, at least one of the first control clock signal CCLK1, the second control clock signal CCLK2, the third control clock signal CCLK3, and the fourth control clock signal CCLK4 may not be toggled in at least some period. In the meantime, as an example thereof, in FIG. 11B, it is illustrated that the third control clock signal CCLK3 and the fourth control clock signal CCLK4 are maintained at a high level H during a period after a transition time PP.

In this case, in the second mode, the first control clock signal CCLK1 and the second control clock signal CCLK2 are toggled during all the periods. Therefore, as an output circuit of a stage to which the first control clock signal CCLK1 and the second control clock signal CCLK2 are applied, first to fourth output circuits OUT1 to OUT4 of k-th to k+3-th stages, for example, first to fourth stages STG1 to STG4 output first to fourth gate signals GATE1 to GATE4 having a low level (L) pulse.

In contrast, in the second mode, the third control clock signal CCLK3 and the fourth control clock signal CCLK4 are maintained at a high level H after the transition time PP. Therefore, gate signals output from fifth to eighth output circuits OUT5 to OUT8 of k+4-th to k+7-th stages, for example, fifth to eighth stages STG5 to STG8, as an output circuit of a stage to which the third control clock signal CCLK3 and the fourth control clock signal CCLK4 are applied, do not output a low level (L) pulse, but may be maintained at a gate-off level which is a high level H after the transition time PP.

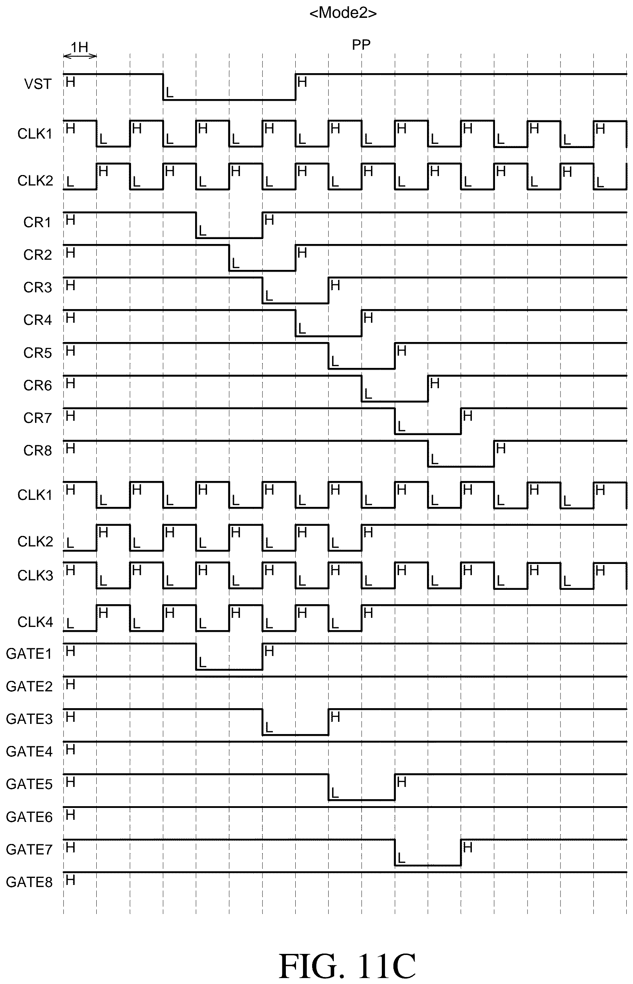

As another example, as illustrated in FIG. 11C, when the second control clock signal CCLK2 and the fourth control clock signal CCLK4 are maintained at a high level H during a period after the transition time PP, in the second mode, gate signals output from an output circuit of a stage to which the second control clock signal CCLK2 and the fourth control clock signal CCLK4 are applied do not output a low level (L) pulse, but may be maintained at a gate-off level which is a high level H after the transition time PP.

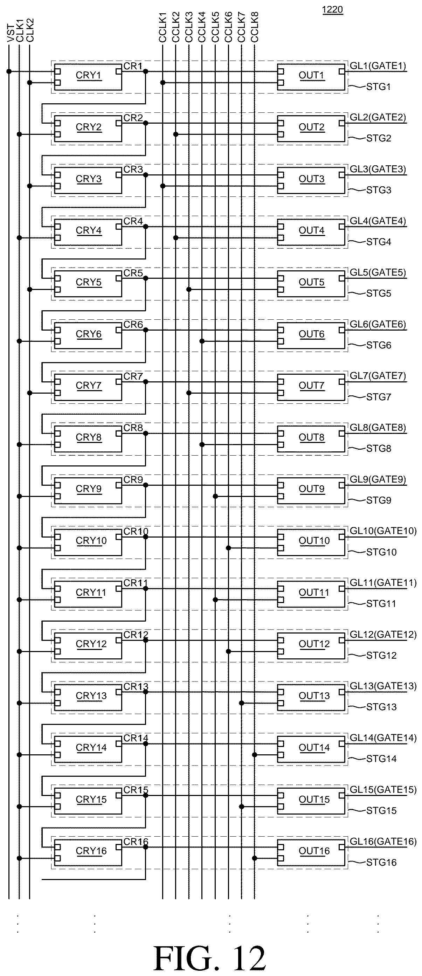

FIG. 12 is a block diagram illustrating still another example of a gate driver of FIG. 5.

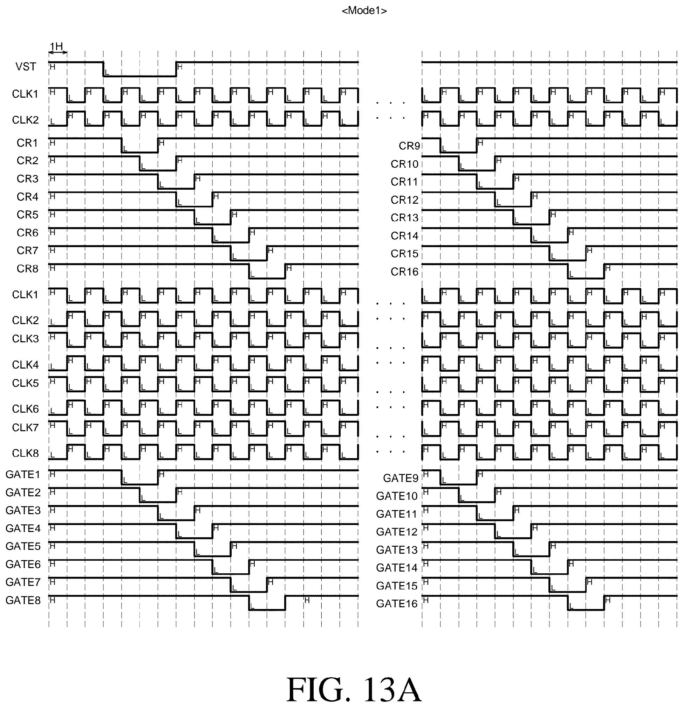

FIGS. 13A to 13C are waveform charts for explaining an example of an operation of a gate driver of FIG. 12.

In the meantime, a gate driver 1220 illustrated in FIG. 12 is a modified embodiment for the gate driver 620 which has been described with reference to FIG. 6, with regard to a plurality of control clock signals CCLK1 to CCLK8 and a connection relationship thereof. Accordingly, for the convenience of description, a redundant description will not be repeated.

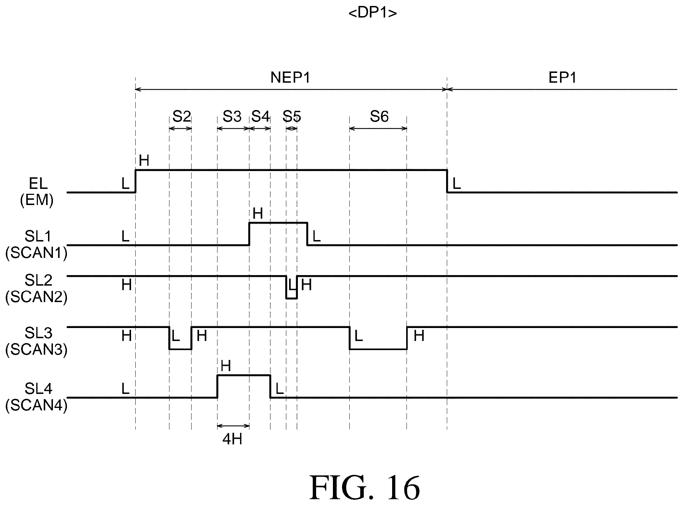

In the meantime, for the convenience of description, in FIG. 12, 16 stages STG1 to STG16 included in the gate driver 1220 and a plurality of gate signals GATE1 to GATE16 output therefrom were illustrated.

Referring to FIG. 12, the gate driver 1220 may include a plurality of stages STG1 to STG16. A plurality of stages STG1 to STG16 is connected to corresponding gate lines GL1 to GL16 to output gate signals GATE1 to GATE16.

Each of the plurality of stages STG1 to STG16 may include carry circuits CRY1 to CRY16 which output a carry signal and output circuits OUT1 to OUT16 which control whether to output a gate signal.

Each of the plurality of carry circuits CRY1 to CRY16 included in the plurality of stages STG1 to STG16 may output carry signals CR1 to CR16 based on an input signal, for example, a start signal VST or a carry signal which is supplied from a carry circuit of a previous stage and a plurality of clock signals CLK1 and CLK2.

Each of the plurality of output circuits OUT1 to OUT16 may be supplied with any one of a plurality of control clock signals, for example, first to eighth control clock signals CCLK1 to CCLK8.

In one example embodiment, output circuits included in a k-th (k is an integer larger than 0) stage and a k+2-th stage receive a first control clock signal CCLK1 and output circuits included in a k+1-th stage and a k+3-th stage receive a second control clock signal CCLK2. Output circuits included in a k+4-th stage and a k+6-th stage receive a third control clock signal CCLK3 and output circuits included in a k+5-th stage and a k+7-th stage receive a fourth control clock signal CCLK4. Further, output circuits included in a k+8-th stage and a k+10-th stage receive a fifth control clock signal CCLK5 and output circuits included in a k+9-th stage and a k+11-th stage receive a sixth control clock signal CCLK6. Output circuits included in a k+12-th stage and a k+14-th stage receive a seventh control clock signal CCLK7 and output circuits included in a k+13-th stage and a k+15-th stage may receive an eighth control clock signal CCLK8.

For example, the first output circuit OUT1 and the third output circuit OUT3 receive a first control clock signal CCLK1, respectively and the second output circuit OUT2 and the fourth output circuit OUT4 receive a second control clock signal CCLK2, respectively. The fifth output circuit OUT5 and the seventh output circuit OUT7 receive a third control clock signal CCLK3, respectively and the sixth output circuit OUT6 and the eighth output circuit OUT8 receive a fourth control clock signal CCLK4, respectively. The ninth output circuit OUT9 and the eleventh output circuit OUT11 receive a fifth control clock signal CCLK5 and the tenth output circuit OUT10 and the twelfth output circuit OUT12 receive a sixth control clock signal CCLK6. The thirteenth output circuit OUT13 and the fifteenth output circuit OUT15 receive a seventh control clock signal CCLK7 and the fourteenth output circuit OUT14 and the sixteenth output circuit OUT16 may receive an eighth control clock signal CCLK8.

The first control clock signal CCLK1 and the second control clock signal CCLK2 have the same cycle and have waveforms in which phases do not overlap each other. For example, the second control clock signal CCLK2 may be set to a signal which is shifted by approximately a half cycle from the first control clock signal CCLK1.

Further, the third control clock signal CCLK3 and the fourth control clock signal CCLK4 have the same cycle and have waveforms in which phases do not overlap each other. For example, the fourth control clock signal CCLK4 may be set to a signal which is shifted by approximately a half cycle from the third control clock signal CCLK3.

Further, the fifth control clock signal CCLK5 and the sixth control clock signal CCLK6 have the same cycle and have waveforms in which phases do not overlap each other. For example, the sixth control clock signal CCLK6 may be set to a signal which is shifted by approximately a half cycle from the fifth control clock signal CCLK5.

Further, the seventh control clock signal CCLK7 and the eighth control clock signal CCLK8 have the same cycle and have waveforms in which phases do not overlap each other. For example, the eighth control clock signal CCLK8 may be set to a signal which is shifted by approximately a half cycle from the seventh control clock signal CCLK7.

In the example embodiment, as described above, except that the gate driver 1220 is driven in a second mode so that any one of the first to eighth control clock signals CCLK1 to CCLK8 is maintained at the high level H, the first control clock signal CCLK1, the third control clock signal CCLK3, the fifth control clock signal CCLK5, and the seventh control clock signal CCLK7 have the same waveform. Further, the second control clock signal CCLK2, the fourth control clock signal CCLK4, the sixth control clock signal CCLK6, and the eighth control clock signal CCLK8 have the same waveform.

In one example embodiment, a signal level of at least any one of the first to eighth control clock signals CCLK1 to CCLK8 may be controlled according to a driving mode. For example, the signal levels of the first to eighth control clock signals CCLK1 to CCLK8 may be independently controlled. For example, as described above, in order to drive the pixel PX in the second display period DP2, at least one of the first to eighth control clock signals CCLK1 to CCLK8 is maintained at a gate-off level, for example, a high level during a corresponding period. Therefore, the output circuit to which the corresponding control clock signal is applied may supply a gate-off level, for example, a high level H of gate signal.

For example, further referring to FIG. 13A, in the first mode, the plurality of carry circuits CRY1 to CRY16 included in a plurality of stages STG1 to STG16 may sequentially output the plurality of carry signals CR1 to CR16, by the start signal VST, the first clock signal CLK1, and the second clock signal CLK2.

In one example embodiment, in the first mode, each of the first to eighth control clock signals CCLK1 to CCLK8 may be toggled between the high level H and the low level L. For example, in the first mode, each of the first to eighth control clock signals CCLK1 to CCLK8 may be shifted from the high level H to the low level L or shifted from the low level L to the high level H at every half cycle.

Accordingly, each of the plurality of output circuits OUT1 to OUT16 included in the plurality of stages STG1 to STG16 may sequentially output a plurality of gate signals GATE1 to GATE16 having a gate-on level pulse, for example, a low level (L) pulse, based on the carry signals CR1 to CR16 supplied from the carry circuits CRY1 to CRY16 of the corresponding stage and the control clock signal.

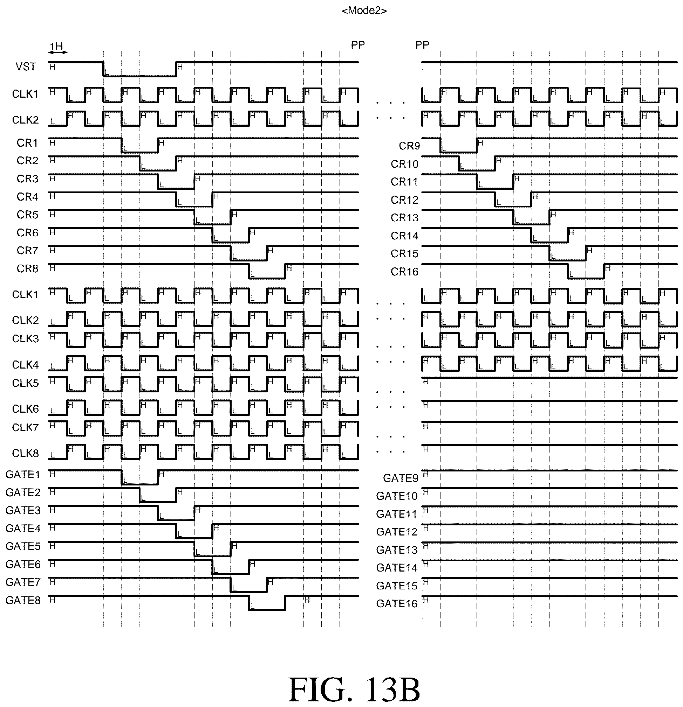

Next, when FIG. 13B is referenced to describe the second mode, as the substantially same as the description which has been made with reference to FIG. 13A, the plurality of carry circuits CRY1 to CRY16 included in the plurality of stages STG1 to STG16 may sequentially output the plurality of carry signals CR1 to CR16, by the start signal VST, the first clock signal CLK1, and the second clock signal CLK2.

In the example embodiment, in the second mode, at least one of the first to eighth control clock signals CCLK1 to CCLK8 may be maintained at a gate-off level, for example, a high level H in at least some period. For example, in the second mode, at least one of the first to eighth control clock signals CCLK1 to CCLK8 may not be toggled in at least some period. In the meantime, as an example thereof, in FIG. 13B, it is illustrated that the fifth to eighth control clock signal CCLK5 to CCLK8 are maintained at a high level H during a period after a transition time PP.

In this case, in the second mode, the first to fourth control clock signals CCLK1 to CCLK4 are toggled in all the periods. Therefore, as an output circuit of a stage to which the first to fourth control clock signals CCLK1 to CCLK4 are applied, the first to eighth output circuits OUT1 to OUT8 of the k-th to k+7-th stages, for example, first to eighth stages STG1 to STG8, may output first to eighth gate signals GATE1 to GATE8 having a low level (L) pulse.

In contrast, in the second mode, the fifth to eighth control clock signals CCLK5 to CCLK8 are maintained at a high level H after the transition time PP. Therefore, gate signals output from ninth to sixteenth output circuits OUT9 to OUT16 of k+8-th to k+15-th stages, for example, ninth to sixteenth stages STG9 to STG16, as an output circuit of a stage to which the fifth to eighth control clock signal CCLK5 to CCLK8 are applied, do not output a low level (L) pulse, but may be maintained at a gate-off level which is a high level H after the transition time PP.

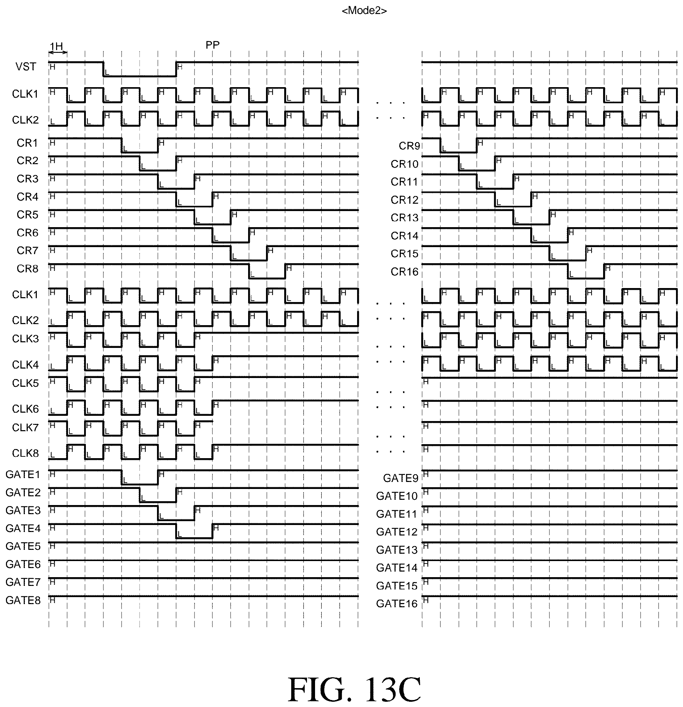

As another example, as illustrated in FIG. 13C, when the third to eighth control clock signals CCLK3 to CCLK8 are maintained at a high level H during a period after the transition time PP, in the second mode, a gate signal output from an output circuit of a stage to which the third to eighth control clock signals CCLK3 to CCLK8 are applied does not output a low level (L) pulse, but may be maintained at a gate-off level which is a high level H after the transition time PP.

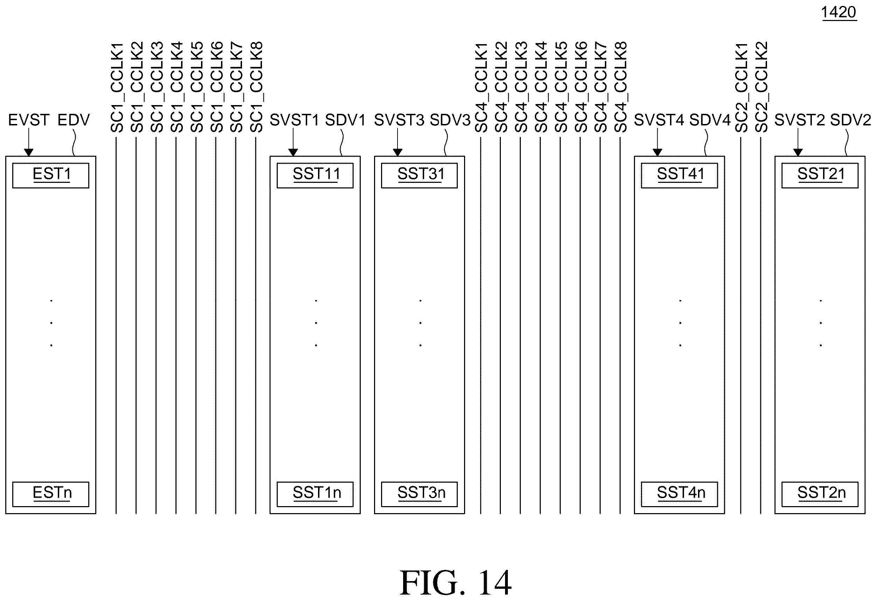

FIG. 14 is a block diagram illustrating an example of a placement relationship of an emission driver, a plurality of scan drivers, and a plurality of signal lines included in a gate driver of FIG. 5.

Referring to FIG. 14, a gate driver 1420 according to an example embodiment of the present disclosure may include a first scan driver SDV1, a second scan driver SDV2, a third scan driver SDV3, a fourth scan driver SDV4, and an emission driver EDV.

In the meantime, as described with reference to FIG. 5, in order to independently drive a driving frequency of a plurality of sub active areas included in an active area AA, output frequencies of the first scan driver SDV1, the second scan driver SDV2, and the fourth scan driver SDV4 may be controlled. To this end, the corresponding scan driver may be implemented as any one of the gate driver 620 which has been described with reference to FIG. 6, the gate driver 1020 which has been described with reference to FIG. 10, and the gate driver 1220 which has been described with reference to FIG. 12.

Here, each pulse width of a control clock signal supplied to an output circuit of each stage has one horizontal period (1H). In the case of the gate driver 620 of FIG. 6, as described above, two control clock signals are applied to the plurality of output circuits OUT1 to OUT4 so that the gate signal output from the gate driver 620 of FIG. 6 may have a pulse width of at most two horizontal periods (2H). Accordingly, only a scan driver whose pulse width of the scan signal is set to be equal to or lower than two horizontal periods (2H), among the first scan driver SDV1, the second scan driver SDV2, and the fourth scan driver SDV4, may be implemented by the gate driver 620 of FIG. 6. For example, when the second scan signal SCAN2 is set to be two horizontal periods (2H) or lower in the pixel PX to write the data signal Vdata, the second scan driver SDV2 is implemented by the gate driver 620 of FIG. 6 to output the second scan signal SCAN2 based on two control clock signals (denoted by SC2_CCLK1 and SC2_CCLK2 in FIG. 14).

In contrast, in the case of the gate driver 1020 of FIG. 10 or the gate driver 1220 of FIG. 12, as described above, the number of control clock signals applied to the plurality of output circuits is four or eight. Therefore, the gate signals output from the gate driver 1020 of FIG. 10 or the gate driver 1220 of FIG. 12 may have a pulse width of two horizontal periods (2H) or more by modifying a pulse width of the start signal VST and a control clock signal waveform. Accordingly, the first scan driver SDV1, the second scan driver SDV2, and the fourth scan driver SDV4 may be implemented by the gate driver 1020 of FIG. 10 or the gate driver 1220 of FIG. 12 regardless of the pulse width of the scan signal. For example, as illustrated in FIG. 14, the first scan driver SDV1 is implemented by the gate driver 1220 of FIG. 12 to output a first scan signal SCAN1 based on eight control clock signals (denoted by SC1_CCLK1 to SC1_CCLK8 in FIG. 14). Further, the fourth scan driver SDV4 is implemented by the gate driver 1220 of FIG. 12 to output a fourth scan signal SCAN4 based on eight control clock signals (denoted by SC1_CCLK1 to SC1_CCLK8 in FIG. 14).

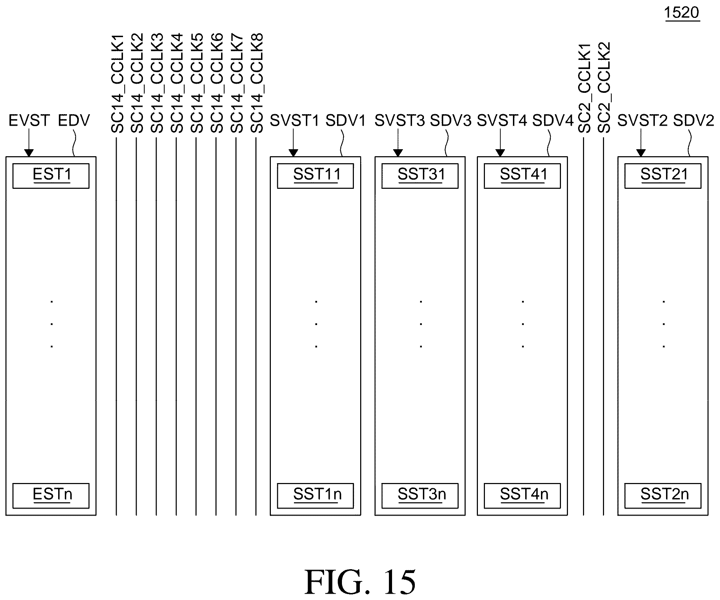

FIG. 15 is a block diagram illustrating another example of a placement relationship of an emission driver, a plurality of scan drivers, and a plurality of signal lines included in a gate driver of FIG. 5.

FIG. 16 is a waveform chart for explaining another example of an operation of a pixel of FIG. 3.

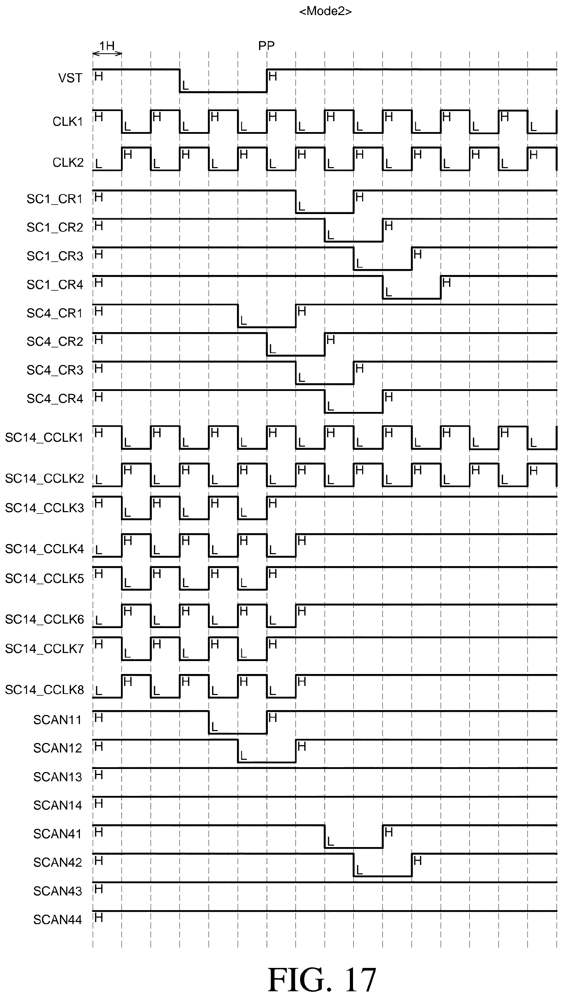

FIG. 17 is a waveform chart for explaining an example of an operation of a first scan driver and a fourth scan driver of FIG. 15.

In the meantime, a gate driver 1520 illustrated in FIG. 15 is a modified embodiment for the gate driver 1420 which has been described with reference to FIG. 14, with regard to a plurality of control clock signals and a connection relationship thereof.

Further, the waveform chart in the first display period DP1 illustrated in FIG. 16 is a modified embodiment for the waveform chart in the first display period DP1 which has been described with reference to FIG. 4A, with regard to the first scan signal SCAN1 and the fourth scan signal SCAN4.

Accordingly, for the convenience of description, a redundant description will not be repeated.

Referring to FIG. 15, a gate driver 1520 according to an example embodiment of the present disclosure may include a first scan driver SDV1, a second scan driver SDV2, a third scan driver SDV3, a fourth scan driver SDV4, and an emission driver EDV. Here, as described above, in order to independently drive a driving frequency of a plurality of sub active areas included in an active area AA, output frequencies of the first scan driver SDV1, the second scan driver SDV2, and the fourth scan driver SDV4 may be controlled. For example, as described with reference to FIG. 14, the second scan driver SDV2 is implemented by the gate driver 620 of FIG. 6 and each of the first scan driver SDV1 and the fourth scan driver SDV4 may be implemented by the gate driver 1220 of FIG. 12.

In the meantime, when a plurality of control clock signals is separately formed for each of the first scan driver SDV1, the second scan driver SDV2, and the fourth scan driver SDV4 whose output frequency is controlled, the number of signal lines for supplying a control clock signal, for example, control clock signal lines is increased. Therefore, there is a problem in that a bezel area of the display device 100 is increased.

Accordingly, in one example embodiment, the first scan driver SDV1 and the fourth scan driver SDV4 may share the plurality of control clock signals (denoted by SC14_CCLK1 to SC14_CCLK8 in FIG. 15).

To this end, further referring to FIG. 16, the first scan signal SCAN1 and the fourth scan signal SCAN4 output from the first scan driver SDV1 have the same pulse width and may be supplied at different timings. For example, each of the first scan signal SCAN1 and the fourth scan signal SCAN4 have one high level (H) pulse and the first scan signal SCAN1 may have a waveform shifted by four horizontal periods (4H) from the fourth scan signal SCAN4. For example, the first scan driver SDV1 and the fourth scan driver SDV4 share a plurality of control clock signals SC14_CCLK1 to SC14_CCLK8. Therefore, the first scan signal SCAN1 has the same magnitude and the same number of pulse widths as the fourth scan signal SCAN4. Further, a pulse width of the first scan signal SCAN1 and a pulse width of the fourth scan signal SCAN4 may be designed to be different by a multiple of four horizontal periods (4H) to be synchronized with a timing when a signal level of the control clock signal is shifted.

In the meantime, unlike the description which has been made with reference to FIG. 4A, in an example embodiment of FIG. 16, the first scan signal SCAN1 has a gate-off level, for example, a low level L, in a first driving period S1 and a second driving period S2. Therefore, the second switching transistor M2 of the pixel PX is maintained in a turned-off state in the first driving period S1 and the second driving period S2. However, the fourth switching transistor M4 and the seventh switching transistor M7 are turned on by the third scan signal SCAN3 supplied in the second driving period S2 to supply a second initialization voltage VAR to the first electrode of the light emitting diode ED and a bias voltage Vobs to the source electrode of the driving transistor DT. Therefore, the initialization operation and the bias operation may be normally performed.

Next, an operation of the gate driver 1520 in the second mode will described with reference to FIG. 17. Carry circuits of the plurality of first scan stages SST11 to SST1n included in the first scan driver SDV1 sequentially output a plurality of carry signals (denoted by SC1_CR1 to SC1_CR4 in FIG. 17) by the start signal VST, the first clock signal CLK1, and the second clock signal CLK2. Carry circuits of the plurality of fourth scan stages SST41 to SST4n included in the fourth scan driver SDV4 may sequentially output a plurality of carry signals (denoted by SC4_CR1 to SC4_CR4) by the start signal VST, the first clock signal CLK1, and the second clock signal CLK2.

In the example embodiment, in the second mode, at least one of the plurality of control clock signals SC14_CCLK1 to SC14_CCLK8 which is shared by the first scan driver SDV1 and the fourth scan driver SDV4 may be maintained at a gate-off level, for example, a high level H in at least some period. As an example thereof, in FIG. 17, it is illustrated that the third to eighth control clock signal SC14_CCLK3 to SC14_CCLK8 may be maintained at a high level H during a period after a transition time PP. In this case, in the second mode, the first scan signal SCAN1 and the fourth scan signal SCAN4 after the transition time PP, that is, the first scan signal (for example, SCAN13, SCAN14) and the fourth scan signal (for example, SCAN43, SCAN44) output to a third pixel row and a fourth pixel row may be output at a high level H which is a gate-off level.

As described above, in the gate driver according to the example embodiment of the present disclosure and the display device including the same, each stage of the gate driver may include a carry circuit which generates a carry signal and an output circuit which controls whether to output a gate signal.

Accordingly, in the gate driver according to the example embodiment of the present disclosure and the display device including the same, an active area is freely divided in response to a display image without being restricted to a fixed area to control a driving frequency for each area.

Further, the driving frequency is controlled in response to the active area to improve a consumed power.

In one or more examples, unless the context clearly indicates otherwise, an element may be one or more elements; and an element may include a plurality of elements. In one or more examples, unless the context clearly indicates otherwise, a gate signal may include multiple gate signals, a gate control signal may include multiple gate control signals, a scan signal may include multiple scan signals, an emission signal may include multiple emission signals, a data signal may include multiple data signals, a data control signal may include multiple data control signals, a clock signal may include multiple clock signals, a control clock signal may include multiple control clock signal, and a display image may include multiple display images. In one or more examples, unless the context clearly indicates otherwise, a gate signal may represent or include a scan signal, and a gate line may represent or include a scan line.

In one or more aspects, the terms such as a first control node, a second control node, a third control node, a first Q node, a first QB node, a second Q node, a second QB node and the like may be used. These terms are intended to identify the corresponding node(s) from the other node(s), and these are not used to define the essence, basis, order, or number of the nodes.

Various examples and aspects of the present disclosure are described below. These are provided as examples, and do not limit the scope of the present disclosure.

According to one or more aspects of the present disclosure, a gate driver includes a plurality of stages which is cascaded and outputs a plurality of gate signals based on an input signal, a plurality of clock signals, a plurality of control clock signals, a first power source, and a second power source which has a voltage level lower than that of the first power source, each of the plurality of stages includes a carry circuit which outputs a carry signal based on the input signal, at least one of the plurality of clock signals, the first power source, and the second power source and an output circuit which outputs a gate signal based on the carry signal, at least one of the plurality of control clock signals, the first power source, and the second power source, and whether to output the gate signal of the output circuit is controlled based on at least one control clock signal.

Each of the plurality of control clock signals may have a waveform which is toggled between a gate-on level and a gate-off level or is maintained at a gate-off level.

In a period in which at least one control clock signal is toggled between the gate-on level and the gate-off level, the output circuit may output the gate signal having a gate-on level pulse, and in a period in which at least one control clock signal has the gate-off level, the output circuit may output the gate signal which is maintained at the gate-off level.

The plurality of control clock signals has a first control clock signal and a second control clock signal, both of whose signal levels are independently controlled and both of whose phases do not overlap each other, the output circuit included in each odd-numbered stage, among the plurality of stages, receives the first control clock signal, and the output circuit included in each even-numbered stage, among the plurality of stages, receives the second control clock signal.

The plurality of control clock signals may include a first control clock signal and a second control clock signal, both of whose signal levels are independently controlled and both of whose phases do not overlap each other, and a third control clock signal and a fourth control clock signal, both of whose signal levels are independently controlled and both of whose phases do not overlap each other.

The output circuit included in each of a k-th stage (k is an integer larger than 0) and a k+2-th stage, among the plurality of stages, may receive the first control clock signal, the output circuit included in each of a k+1-th stage and a k+3-th stage, among the plurality of stages, may receive the second control clock signal, the output circuit included in each of a k+4-th stage and a k+6-th stage, among the plurality of stages, may receive the third control clock signal, and the output circuit included in each of a k+5-th stage and a k+7-th stage, among the plurality of stages, may receive the fourth control clock signal.

In at least one or more periods, the first control clock signal and the third control clock signal may have the same waveform, and in at least one or more periods, the second control clock signal and the fourth control clock signal may have the same waveform.

The plurality of control clock signals may further include a fifth control clock signal and a sixth control clock signal, both of whose signal levels are independently controlled and both of whose phases do not overlap each other, and a seventh control clock signal and an eighth control clock signal, both of whose signal levels are independently controlled and both of whose phases do not overlap each other.

The output circuit included in each of a k+8-th stage and a k+10-th stage, among the plurality of stages, may receive the fifth control clock signal, the output circuit included in each of a k+9-th stage and a k+11-th stage, among the plurality of stages, may receive the sixth control clock signal, the output circuit included in each of a k+12-th stage and a k+14-th stage, among the plurality of stages, may receive the seventh control clock signal, and the output circuit included in each of a k+13-th stage and a k+15-th stage, among the plurality of stages, may receive the eighth control clock signal.

In at least one or more periods, the first control clock signal, the third control clock signal, the fifth control clock signal, and the seventh control clock signal may have the same waveform, and in at least one or more periods, the second control clock signal, the fourth control clock signal, the sixth control clock signal, and the eighth control clock signal may have the same waveform.

The carry circuit may include a first transistor which is connected between a first input terminal supplied with the input signal and a first control node and include a gate electrode connected to a second input terminal supplied with at least one clock signal, a second transistor which is connected between a second control node and a first power input terminal supplied with a voltage of the first power source and includes a gate electrode connected to the first input terminal, a third transistor which is connected between the second input terminal and a first QB node and includes a gate electrode connected to the second control node, a fourth transistor which is connected between the first power input terminal and the first QB node and includes a gate electrode connected to the first control node, a fifth transistor which is connected between a second power input terminal supplied with a voltage of the second power source and a first output terminal through which the carry signal is output and includes a gate electrode connected to a first Q node, a sixth transistor which is connected between the first power input terminal and the first output terminal and includes a gate electrode connected to the first QB node, a first bridge voltage transistor which is connected between the first control node and the first Q node and includes a gate electrode connected to the second power input terminal and a first capacitor which is connected between the second input terminal and the second control node.

The carry circuit may further include a second capacitor connected between the first Q node and the first output terminal and a third capacitor which is connected between the first QB node and the first power input terminal.

The output circuit may include a seventh transistor which is connected between a third input terminal supplied with the carry signal and a third control node and includes a gate electrode connected to a fourth input terminal supplied with at least one control clock signal, an eighth transistor which is connected between a fourth control node and a first power input terminal supplied with a voltage of the first power source and includes a gate electrode connected to the third input terminal, a ninth transistor which is connected between the fourth input terminal and a second QB node and includes a gate electrode connected to the fourth control node, a tenth transistor which is connected between the first power input terminal and the second QB node and includes a gate electrode connected to the third control node, an eleventh transistor which is connected between a second power input terminal supplied with a voltage of the second power source and a second output terminal through which the gate signal is output and includes a gate electrode connected to a second Q node, a twelfth transistor which is connected between the first power input terminal and the second output terminal and includes a gate electrode connected to the second QB node, a second bridge voltage transistor which is connected between the third control node and the second Q node and includes a gate electrode connected to the second power input terminal and a fourth capacitor which is connected between the fourth input terminal and the fourth control node.

The output circuit may include a fifth capacitor connected between the second Q node and the second output terminal and a sixth capacitor which is connected between the second QB node and the first power input terminal.

The input signal of the carry circuit of a first stage among the plurality of stages may be a first signal, such as a start signal. The input signal of the carry circuit of a second stage among the plurality of stages may be the carry signal being outputted by the carry circuit of the first stage.

According to one or more aspects of the present disclosure, a display device includes a display panel which includes a plurality of pixels and a first scan driver, a second scan driver, a third scan driver, and a fourth scan driver which output a first scan signal, a second scan signal, a third scan signal, and a fourth scan signal to the plurality of pixels, respectively, based on an input signal, a plurality of clock signals, a plurality of control clock signals, a first power source, and a second power source which has a voltage level lower than that of the first power source, in a first display period, each of the first scan signal, the second scan signal, the third scan signal, and the fourth scan signal has a gate-on level pulse, in a second display period which is different from the first display period, the third scan signal has a gate-on level pulse and the first scan signal, the second scan signal, and the fourth scan signal are maintained at a gate-off level, and at least some of the first scan driver, the second scan driver, and the fourth scan driver control signal levels of scan signals based on a same control clock signal, among the plurality of control clock signals.

The display panel may include an active area and a non-active area and the active area includes a plurality of sub active areas which is divided such that each sub active area corresponds to a display image.

According to one or more aspects of the present disclosure, a display device includes: an active area for providing images, wherein the active area is dividable into sub active areas that are not fixed areas; and a gate driver comprising a first scan driver and a second scan driver. The display device may be configured to control driving frequencies of the sub active areas based on display images. Each of the first scan driver and the second scan driver may include: a carry circuit for generating a carry signal; and an output circuit for controlling whether or not to output a gate signal. The first scan driver may be configured to use a first driving frequency for a first sub active area of the sub active areas and to drive at least a first pixel in the first sub active area based on at least a first control clock signal, the at least a first control clock signal controlling whether or not to output a first gate signal of the first scan driver to the at least a first pixel at a given period. The second scan driver may be configured to use a second driving frequency for a second sub active area of the sub active areas and to drive at least a second pixel in the second sub active area based on at least a second control clock signal, the at least a second control clock signal controlling whether or not to output a second gate signal of the second scan driver to the at least a second pixel at a given period.

The display device may be configured to determine the first driving frequency and the second driving frequency based on the display images. The display device may be configured to determine the first sub active area and the second sub active area based on a position where the driving frequencies are divided into the first driving frequency and the second driving frequency. A timing controller may be configured to determine the at least a first control clock signal and the at least a second control clock signal based on the first driving frequency and the second driving frequency, respectively. The second driving frequency may be different from the first driving frequency. The at least a second control clock signal may be different from the at least a first control clock signal.

The display device may be configured to select the first driving frequency and the second driving frequency, dynamically in real time, in response to the display images. The display device may be configured to divide the active area into the first sub active area and the second sub active area and determine respective locations of the first sub active area and the second sub active area, dynamically in real time, in response to the display images.

As given display images change in real time, a position where the driving frequencies are divided into the first driving frequency and the second driving frequency may vary in real time based on the changing given display images, and locations of sub active areas of the active area may vary in real time based on the changing given display images.

In at least one or more first periods, the at least a first control clock signal and the at least a second control clock signal may have a same waveform. In at least one or more second periods, the at least a first control clock signal and the at least a second control clock signal may have different waveforms.

A timing controller may be configured to control the driving frequency of each of the sub active areas, at least by providing, to the gate driver, the at least a first control clock signal and the at least a second control clock signal that are different from each other.

In an example, the display device (e.g., a controller) may determine (or select) the first driving frequency and the second driving frequency based on the display images. The controller may include memories and/or buffers for storing data and a processor (e.g., an image signal processor or a graphics processor) including logic circuit for performing computation. In an example, the controller may refer to the timing controller and vice versa. In an example, the controller may include the timing controller, or the timing controller may include the controller.

The controller may determine whether a display image is, or includes, a moving image or a still image by, for example, comparing successive frames. The controller may determine (or select) a driving frequency based on the type of image. In one example, a first driving frequency (e.g., a high driving frequency) may be selected for a moving image, and a second driving frequency (e.g., a low driving frequency) may be selected for a still image. The controller may determine a first sub active area (or the location of the first sub active area) for displaying the moving image using the first driving frequency. The controller may determine a second sub active area (or the location of the second sub active area) for displaying the still image using the second driving frequency. The controller may determine a position (e.g., a boundary between the moving image and the still image) where the driving frequencies are divided into the first driving frequency and the second driving frequency. The controller may then determine the first sub active area and the second sub active area (or locations of the first and second sub active areas) based on the determined position. The controller may perform the foregoing activities dynamically in real time as display images are being processed for display in the active area.

The following numbered examples pertain to embodiments of the present disclosure.

Example 1: A gate driver, comprising: a plurality of stages which is cascaded and is configured to output a plurality of gate signals based on an input signal, a plurality of clock signals, a plurality of control clock signals, a first power source, and a second power source which has a voltage level lower than a voltage level of the first power source, wherein each of the plurality of stages includes: a carry circuit which is configured output a carry signal based on the input signal, at least one of the plurality of clock signals, the first power source, and the second power source; and an output circuit which is configured output a gate signal based on the carry signal, at least one of the plurality of control clock signals, the first power source, and the second power source, and wherein whether to output the gate signal of the output circuit is controlled based on at least one control clock signal.

Example 2: The gate driver according to Example 1, wherein each of the plurality of control clock signals has a waveform which is toggled between a gate-on level and a gate-off level or is maintained at a gate-off level.

Example 3: The gate driver according to Example 2, wherein in a period in which at least one control clock signal is toggled between the gate-on level and the gate-off level, the output circuit outputs the gate signal having a gate-on level pulse, and wherein in a period in which at least one control clock signal has the gate-off level, the output circuit outputs the gate signal which is maintained at the gate-off level.

Example 4: The gate driver according to any of Examples 1 to 3, wherein the plurality of control clock signals includes a first control clock signal and a second control clock signal, wherein signal levels of the first control clock signal and the second control clock signal are independently controlled, and phases of the first control clock signal and the second control clock signal do not overlap each other, wherein the output circuit included in each odd-numbered stage, among the plurality of stages, is configured to receive the first control clock signal, and wherein the output circuit included in each even-numbered stage, among the plurality of stages, is configured to receive the second control clock signal.

Example 5: The gate driver according to any of Examples 1 to 3, wherein the plurality of control clock signals includes: a first control clock signal and a second control clock signal, wherein signal levels of the first control clock signal and the second control clock signal are independently controlled, and phases of the first control clock signal and the second control clock signal do not overlap each other; and a third control clock signal and a fourth control clock signal, wherein signal levels of the third control clock signal and the fourth control clock signal are independently controlled, and phases of the third control clock signal and the fourth control clock signal do not overlap each other.

Example 6: The gate driver according to Example 5, wherein the output circuit included in each of a k-th stage (wherein k is an integer larger than 0) and a k+2-th stage, among the plurality of stages, is configured to receive the first control clock signal, the output circuit included in each of a k+1-th stage and a k+3-th stage, among the plurality of stages, is configured to receive the second control clock signal, the output circuit included in each of a k+4-th stage and a k+6-th stage, among the plurality of stages, is configured to receive the third control clock signal, and the output circuit included in each of a k+5-th stage and a k+7-th stage, among the plurality of stages, is configured to receive the fourth control clock signal.

Example 7: The gate driver according to Example 5 or 6, wherein in at least one or more periods, the first control clock signal and the third control clock signal have a same waveform, and wherein in at least one or more periods, the second control clock signal and the fourth control clock signal have a same waveform.

Example 8: The gate driver according to any of Examples 5 to 7, wherein the plurality of control clock signals further includes: a fifth control clock signal and a sixth control clock signal, wherein signal levels of the fifth control clock signal and the sixth control clock signal are independently controlled, and phases of the fifth control clock signal and the sixth control clock signal do not overlap each other; and a seventh control clock signal and an eighth control clock signal, wherein signal levels of the seventh control clock signal and the eighth control clock signal are independently controlled, and phases of the seventh control clock signal and the eighth control clock signal do not overlap each other.

Example 9: The gate driver according to Example 8, wherein the output circuit included in each of a k+8-th stage and a k+10-th stage, among the plurality of stages, is configured to receive the fifth control clock signal, the output circuit included in each of a k+9-th stage and a k+11-th stage, among the plurality of stages, is configured to receive the sixth control clock signal, the output circuit included in each of a k+12-th stage and a k+14-th stage, among the plurality of stages, is configured to receive the seventh control clock signal, and the output circuit included in each of a k+13-th stage and a k+15-th stage, among the plurality of stages, is configured to receive the eighth control clock signal.

Example 10: The gate driver according to Example 8 or 9, wherein in at least one or more periods, the first control clock signal, the third control clock signal, the fifth control clock signal, and the seventh control clock signal have a same waveform, and wherein in at least one or more periods, the second control clock signal, the fourth control clock signal, the sixth control clock signal, and the eighth control clock signal have a same waveform.

Example 11: The gate driver according to any of Examples 1 to 10, wherein the carry circuit includes: a first transistor which is connected between a first input terminal for receiving the input signal and a first control node, and includes a gate electrode connected to a second input terminal for receiving at least one clock signal; a second transistor which is connected between a second control node and a first power input terminal for receiving a voltage of the first power source, and includes a gate electrode connected to the first input terminal; a third transistor which is connected between the second input terminal and a first QB node, and includes a gate electrode connected to the second control node; a fourth transistor which is connected between the first power input terminal and the first QB node, and includes a gate electrode connected to the first control node; a fifth transistor which is connected between a second power input terminal for receiving a voltage of the second power source and a first output terminal for outputting the carry signal, and includes a gate electrode connected to a first Q node; a sixth transistor which is connected between the first power input terminal and the first output terminal, and includes a gate electrode connected to the first QB node; a first bridge voltage transistor which is connected between the first control node and the first Q node, and includes a gate electrode connected to the second power input terminal; and a first capacitor which is connected between the second input terminal and the second control node.

Example 12: The gate driver according to Example 11, wherein the carry circuit further includes: a second capacitor connected between the first Q node and the first output terminal; and a third capacitor which is connected between the first QB node and the first power input terminal.

Example 13: The gate driver according to any of Examples 1 to 12, wherein the output circuit includes: a seventh transistor which is connected between a third input terminal for receiving the carry signal and a third control node, and includes a gate electrode connected to a fourth input terminal for receiving at least one control clock signal; an eighth transistor which is connected between a fourth control node and a first power input terminal for receiving a voltage of the first power source, and includes a gate electrode connected to the third input terminal; a ninth transistor which is connected between the fourth input terminal and a second QB node, and includes a gate electrode connected to the fourth control node; a tenth transistor which is connected between the first power input terminal and the second QB node, and includes a gate electrode connected to the third control node; an eleventh transistor which is connected between a second power input terminal for receiving a voltage of the second power source and a second output terminal for outputting the gate signal, and includes a gate electrode connected to a second Q node; a twelfth transistor which is connected between the first power input terminal and the second output terminal, and includes a gate electrode connected to the second QB node; and a second bridge voltage transistor which is connected between the third control node and the second Q node, and includes a gate electrode connected to the second power input terminal; and a fourth capacitor which is connected between the fourth input terminal and the fourth control node.

Example 14: The gate driver according to Example 13, wherein the output circuit further includes: a fifth capacitor connected between the second Q node and the second output terminal; and a sixth capacitor which is connected between the second QB node and the first power input terminal.

Example 15: The gate driver according to any of Examples 1 to 14, wherein the input signal of the carry circuit of a first stage among the plurality of stages is a first signal, and wherein the input signal of the carry circuit of a second stage among the plurality of stages is the carry signal being outputted by the carry circuit of the first stage.

Example 16: A display device, comprising: a display panel which includes a plurality of pixels; and a first scan driver, a second scan driver, a third scan driver, and a fourth scan driver which are configured to output a first scan signal, a second scan signal, a third scan signal, and a fourth scan signal to the plurality of pixels, respectively, based on an input signal, a plurality of clock signals, a plurality of control clock signals, a first power source, and a second power source which has a voltage level lower than that of the first power source, wherein: in a first display period, each of the first scan signal, the second scan signal, the third scan signal, and the fourth scan signal has a gate-on level pulse; in a second display period which is different from the first display period, the third scan signal has a gate-on level pulse, and the first scan signal, the second scan signal, and the fourth scan signal are maintained at a gate-off level; and at least some of the first scan driver, the second scan driver, and the fourth scan driver are configured to control signal levels of scan signals based on a same control clock signal, among the plurality of control clock signals.

Example 17: The display device according to Example 16, wherein the display panel includes an active area and a non-active area, and wherein the active area includes a plurality of sub active areas which is divided such that each sub active area corresponds to a display image.

Example 18: A display device, comprising: a display panel including an active area for providing images, wherein the active area is dividable into sub active areas that are not fixed areas; and a gate driver comprising a first scan driver and a second scan driver, wherein the display device is configured to control driving frequencies of the sub active areas based on display images, wherein each of the first scan driver and the second scan driver comprises: a carry circuit for generating a carry signal; and an output circuit for controlling whether or not to output a gate signal, wherein the first scan driver is configured to use a first driving frequency for a first sub active area of the sub active areas and to drive at least a first pixel in the first sub active area based on at least a first control clock signal, the at least a first control clock signal controlling whether or not to output a first gate signal of the first scan driver to the at least a first pixel at a given period, and wherein the second scan driver is configured to use a second driving frequency for a second sub active area of the sub active areas and to drive at least a second pixel in the second sub active area based on at least a second control clock signal, the at least a second control clock signal controlling whether or not to output a second gate signal of the second scan driver to the at least a second pixel at a given period.

Example 19: The display device according to Example 18, wherein the display device is configured to determine the first driving frequency and the second driving frequency based on the display images, wherein the display device is configured to determine the first sub active area and the second sub active area based on a position where the driving frequencies are divided into the first driving frequency and the second driving frequency, wherein a timing controller is configured to determine the at least a first control clock signal and the at least a second control clock signal based on the first driving frequency and the second driving frequency, respectively, wherein the second driving frequency is different from the first driving frequency, and wherein the at least a second control clock signal is different from the at least a first control clock signal.

Example 20: The display device according to Example 18, wherein the display device is configured to select the first driving frequency and the second driving frequency, dynamically in real time, in response to the display images, and wherein the display device is configured to divide the active area into the first sub active area and the second sub active area and determine respective locations of the first sub active area and the second sub active area, dynamically in real time, in response to the display images.

## Claims

1. A gate driver (120, 620, 1020, 1220, 1420, 1520), comprising:
a plurality of stages (STG1, ..., STG16) which is cascaded and is configured to output a plurality of gate signals (GATE1, ..., GATE16) based on an input signal, a plurality of clock signals (CLK1, CLK2), a plurality of control clock signals (CCLK1, ..., CCLK8), a first power source (VGH), and a second power source (VGL) which has a voltage level lower than a voltage level of the first power source (VGH),
wherein each of the plurality of stages (STG1, ..., STG16) includes:
a carry circuit (CRY1, ..., CRY16) which is configured output a carry signal (CR1, ..., CR16) based on the input signal, at least one of the plurality of clock signals (CLK1, CLK2), the first power source (VGH), and the second power source (VGL); and
an output circuit (OUT1, ..., OUT16) which is configured to output a gate signal (GATE1, ..., GATE16) based on the carry signal (CR1, ..., CR16), at least one of the plurality of control clock signals (CCLK1, ..., CCLK8), the first power source (VGH), and the second power source (VGL), and
wherein whether to output the gate signal (GATE1, ..., GATE16) of the output circuit (OUT1, ..., OUT16) is controlled based on at least one control clock signal (CCLK1, ..., CCLK8).

2. The gate driver (120, 620, 1020, 1220, 1420, 1520) according to claim 1, wherein each of the plurality of control clock signals (CCLK1, ..., CCLK8) has a waveform which is toggled between a gate-on level and a gate-off level or is maintained at a gate-off level.

3. The gate driver (120, 620, 1020, 1220, 1420, 1520) according to claim 2, wherein in a period in which at least one control clock signal (CCLK1, ..., CCLK8) is toggled between the gate-on level and the gate-off level, the output circuit (OUT1, ..., OUT16) outputs the gate signal (GATE1, ..., GATE16) having a gate-on level pulse, and
wherein in a period in which at least one control clock signal (CCLK1, ..., CCLK8) has the gate-off level, the output circuit (OUT1, ..., OUT16) outputs the gate signal (GATE1, ..., GATE16) which is maintained at the gate-off level.

4. The gate driver (120, 620) according to any of claims 1 to 3, wherein the plurality of control clock signals (CCLK1, CCLK2) includes a first control clock signal (CCLK1) and a second control clock signal (CCLK2),
wherein signal levels of the first control clock signal (CCLK1) and the second control clock signal (CCLK2) are independently controlled, and phases of the first control clock signal (CCLK1) and the second control clock signal (CCLK2) do not overlap each other,
wherein the output circuit (OUT1, OUT3) included in each odd-numbered stage (STG1, STG3), among the plurality of stages (STG1, ..., STG4), is configured to receive the first control clock signal (CCLK1), and
wherein the output circuit (OUT2, OUT4) included in each even-numbered stage (STG2, STG4), among the plurality of stages (STG1, ..., STG4), is configured to receive the second control clock signal (CCLK2).

5. The gate driver (120, 1020, 1220) according to any of claims 1 to 3, wherein the plurality of control clock signals (CCLK1, ..., CCLK8) includes:
a first control clock signal (CCLK1) and a second control clock signal (CCLK2), wherein signal levels of the first control clock signal (CCLK1) and the second control clock signal (CCLK2) are independently controlled, and phases of the first control clock signal (CCLK1) and the second control clock signal (CCLK2) do not overlap each other; and
a third control clock signal (CCLK3) and a fourth control clock signal (CCLK4), wherein signal levels of the third control clock signal (CCLK3) and the fourth control clock signal (CCLK4) are independently controlled, and phases of the third control clock signal (CCLK3) and the fourth control clock signal (CCLK4) do not overlap each other.

6. The gate driver (120, 1020, 1220) according to claim 5, wherein the output circuit included in each of a k-th stage (STG1, STG3) and a k+2-th stage, among the plurality of stages (STG1, ..., STG16), is configured to receive the first control clock signal (CCLK1),
the output circuit (OUT1, ..., OUT16) included in each of a k+1-th stage (STG2) and a k+3-th stage (STG4), among the plurality of stages (STG1, ..., STG16), is configured to receive the second control clock signal (CCLK2),
the output circuit (OUT1, ..., OUT16) included in each of a k+4-th stage (STG5) and a k+6-th stage (STG7), among the plurality of stages (STG 1, ..., STG16), is configured to receive the third control clock signal (CCLK3), and
the output circuit (OUT1, ..., OUT16) included in each of a k+5-th stage (STG6) and a k+7-th stage (STG8), among the plurality of stages (STG1, ..., STG16), is configured to receive the fourth control clock signal (CCLK4),
wherein k is an integer larger than 0.

7. The gate driver (120, 1020, 1220) according to claim 5 or 6, wherein in at least one or more periods, the first control clock signal (CCLK1) and the third control clock signal (CCLK3) have a same waveform, and
wherein in at least one or more periods, the second control clock signal (CCLK2) and the fourth control clock signal (CCLK4) have a same waveform.

8. The gate driver (120, 1220) according to any of claims 5 to 7, wherein the plurality of control clock signals (CCLK1, ..., CCLK8) further includes:
a fifth control clock signal (CCLK5) and a sixth control clock signal (CCLK6), wherein signal levels of the fifth control clock signal (CCLK5) and the sixth control clock signal (CCLK6) are independently controlled, and phases of the fifth control clock signal (CCLK5) and the sixth control clock signal (CCLK6) do not overlap each other; and
a seventh control clock signal (CCLK7) and an eighth control clock signal (CCLK8), wherein signal levels of the seventh control clock signal (CCLK7) and the eighth control clock signal (CCLK8) are independently controlled, and phases of the seventh control clock signal (CCLK7) and the eighth control clock signal (CCLK8) do not overlap each other.

9. The gate driver (120, 1220) according to claim 8, wherein the output circuit (OUT9, OUTI11) included in each of a k+8-th stage (STG9) and a k+10-th stage (STG11), among the plurality of stages (STG1, ..., STG16), is configured to receive the fifth control clock signal (CCLK5),
the output circuit (OUT1, ..., OUT16) included in each of a k+9-th stage and a k+11-th stage, among the plurality of stages (STG1, ..., STG16), is configured to receive the sixth control clock signal (CCLK6),
the output circuit (OUT1, ..., OUT16) included in each of a k+12-th stage and a k+14-th stage, among the plurality of stages (STG1, ..., STG16), is configured to receive the seventh control clock signal (CCLK7), and
the output circuit (OUT1, ..., OUT16) included in each of a k+13-th stage and a k+15-th stage, among the plurality of stages (STG1, ..., STG16), is configured to receive the eighth control clock signal (CCLK8).

10. The gate driver (120, 1220) according to claim 8 or 9, wherein in at least one or more periods, the first control clock signal (CCLK1), the third control clock signal (CCLK3), the fifth control clock signal (CCLK5), and the seventh control clock signal (CCLK7) have a same waveform, and
wherein in at least one or more periods, the second control clock signal (CCLK2), the fourth control clock signal (CCLK4), the sixth control clock signal (CCLK6), and the eighth control clock signal (CCLK8) have a same waveform.

11. The gate driver (120, 620, 1020, 1220, 1420, 1520) according to any of claims 1 to 10, wherein the carry circuit (CRY1, ..., CRY16) includes:
a first transistor (T1) which is connected between a first input terminal (621) for receiving the input signal and a first control node (CN1), and includes a gate electrode connected to a second input terminal (622) for receiving at least one clock signal (CLK2);
a second transistor (T2) which is connected between a second control node (CN2) and a first power input terminal (628) for receiving a voltage of the first power source (VGH), and includes a gate electrode connected to the first input terminal (621);
a third transistor (T3) which is connected between the second input terminal (622) and a first QB node (QB1), and includes a gate electrode connected to the second control node (CN2);
a fourth transistor (T4) which is connected between the first power input terminal (628) and the first QB node (QB1), and includes a gate electrode connected to the first control node (CN1);
a fifth transistor (T5) which is connected between a second power input terminal (629) for receiving a voltage of the second power source (VGL) and a first output terminal (623) for outputting the carry signal (CR1, ..., CR16), and includes a gate electrode connected to a first Q node (Q1);
a sixth transistor (T6) which is connected between the first power input terminal (628) and the first output terminal (623), and includes a gate electrode connected to the first QB node (QB1);
a first bridge voltage transistor (Tbv1) which is connected between the first control node (CN1) and the first Q node (Q1), and includes a gate electrode connected to the second power input terminal (629); and
a first capacitor (C1) which is connected between the second input terminal (622) and the second control node (CN2).

12. The gate driver (120, 620, 1020, 1220, 1420, 1520) according to claim 11, wherein the carry circuit (CRY1, ..., CRY16) further includes:
a second capacitor (C2) connected between the first Q node (Q1) and the first output terminal (623); and
a third capacitor (C3) which is connected between the first QB node (QB1) and the first power input terminal (628).

13. The gate driver (120, 620, 1020, 1220, 1420, 1520) according to any of claims 1 to 12, wherein the output circuit (OUT1, ..., OUT16) includes:
a seventh transistor (T7) which is connected between a third input terminal (624) for receiving the carry signal (CR1, ..., CR16) and a third control node (CN3), and includes a gate electrode connected to a fourth input terminal (625) for receiving at least one control clock signal (CCLK1);
an eighth transistor (T8) which is connected between a fourth control node (CN4) and a first power input terminal (628) for receiving a voltage of the first power source (VGH), and includes a gate electrode connected to the third input terminal (624);
a ninth transistor (T9) which is connected between the fourth input terminal (625) and a second QB node (QB2), and includes a gate electrode connected to the fourth control node (CN4);
a tenth transistor (T10) which is connected between the first power input terminal (628) and the second QB node (QB2), and includes a gate electrode connected to the third control node (CN3);
an eleventh transistor (T11) which is connected between a second power input terminal (629) for receiving a voltage of the second power source (VGL) and a second output terminal (626) for outputting the gate signal (GATE1, ..., GATE16), and includes a gate electrode connected to a second Q node (Q2);
a twelfth transistor (T12) which is connected between the first power input terminal (628) and the second output terminal (626), and includes a gate electrode connected to the second QB node (QB2); and
a second bridge voltage transistor (Tbv2) which is connected between the third control node (CN3) and the second Q node (Q2), and includes a gate electrode connected to the second power input terminal (629); and
a fourth capacitor (C4) which is connected between the fourth input terminal (625) and the fourth control node (CN4).

14. The gate driver (120, 620, 1020, 1220, 1420, 1520) according to claim 13, wherein the output circuit (OUT1, ..., OUT16) further includes:
a fifth capacitor (C5) connected between the second Q node (Q2) and the second output terminal (626); and
a sixth capacitor (C6) which is connected between the second QB node (QB2) and the first power input terminal (628).

15. The gate driver (120, 620, 1020, 1220, 1420, 1520) according to any of claims 1 to 14, wherein the input signal of the carry circuit (CRY1) of a first stage (STG1) among the plurality of stages (STG1, ..., STG16) is a first signal (VST), and
wherein the input signal of the carry circuit (CRY2) of a second stage (STG2) among the plurality of stages (STG1, ..., STG16) is the carry signal (CR1) being outputted by the carry circuit (CRY1) of the first stage (STG1).
